# EUROPEAN PATENT APPLICATION

(11) **EP 4 832 674 A1**
(43) Date of publication of application: **28.10.2026**
(21) Application number: 26157440.4
(22) Date of filing: 10.02.2026
(51) Int. Cl.: H05K 1/185, H05K 3/46

(54) **METHOD FOR MANUFACTURING A COMPONENT CARRIER**

(71) Applicant: AT & S Austria Technologie & Systemtechnik Aktiengesellschaft, 8700 Leoben-Hinterberg (AT)
(72) Inventor: DONATELLO, Daniele, 8700 Leoben (AT); LEYPOLD, Christian, 8430 Leibnitz (AT); GROBER, Gernot, 8741 Weißkirchen (AT); ZLUC, Andreas, 8700 Leoben (AT); KIRCHHEIMER, Karl Philipp, 8700 Leoben (AT); SCHOBER, Mario, 8793 Trofaiach (AT)
(74) Representative: Donatello, Daniele

(57) **Abstract**

The present invention relates to a method for manufacturing of component carrier (100), wherein the method comprises providing a stack (110) comprising at least one electrically conductive layer structure (104) and at least one electrically insulating layer structure (102);
providing a cavity (150) at least partially extending in the stack (110);
inserting at least one component (140) in the cavity (150);
providing an encapsulant material (120) on the at least one component (140) and flowing the encapsulant material (120) inside the cavity (150) at least partially embedding the at least one component (140).

## Description

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

For example, in manufacturing a component carrier comprising a stack comprising at least one electrically conductive layer structure and at least one electrically insulating layer structure; having a component in the stack and providing an encapsulant material for embedding the component may be challenging. Especially, during manufacturing the encapsulant material gets flowable and ensuring a reliable embedding of the component by the flowable encapsulant material is not easy.

There may be a need to provide a component carrier comprising a stack comprising at least one electrically conductive layer structure and at least one electrically insulating layer structure; provide a cavity at least partially extending in the stack; insert at least one component in the cavity; provide an encapsulant material on the component and flow the encapsulant material inside the cavity at least partially embedding the component.

In order to achieve the object defined above, a component carrier and a method of manufacturing the component carrier according to the independent claims are provided. The dependent claims describe advantageous embodiments.

### Field of the Invention

According to the first aspect of the present invention, a component carrier is provided, wherein the component carrier comprises: a stack comprising at least one electrically conductive layer structure and at least one electrically insulating layer structure; a cavity at least partially extending in the stack; at least one component provided in the stack; an encapsulant material flowed in the cavity, at least partially embedding the at least one component in the cavity; a further material flowed against the encapsulant material, defining with the encapsulant material a boundary profile. The further material comprises fillers embedded therein, said fillers affecting the shape of the boundary profile. Preferably, the encapsulant material is in contact with at least three surfaces or sides of the at least one component. In an example, the encapsulant material may be in contact with a first main surface of the at least one component, a lateral wall of the at least one component and a second (opposed) main surface of the at least one component. Preferably, the encapsulant material comprises a first flowable (insulating) material. The further material may comprise a second flowable (insulating) material. The first flowable material and the second flowable material may comprise electrically insulating material, for example epoxy resin and/or poly (meth)acrylate. The first flowable material and the second flowable material may comprise the same electrically insulating material. The encapsulant material comprising the first flowable material and the further material comprising the second flowable material may be distinguishable from each other, for example in a cross-section image. The encapsulant material may comprise reinforcing fillers, for example reinforcing spheres. The encapsulant material may be free from fibers.

According to a second aspect of the present invention, a method of manufacturing a component carrier is provided, wherein the method of manufacturing the component carrier comprises: providing a stack comprising at least one electrically conductive layer structure and at least one electrically insulating layer structure; providing a cavity at least partially extending in the stack; inserting at least one component in the cavity; providing a encapsulant material on the at least one component; flowing the encapsulant material inside the cavity at least partially embedding the at least one component. Preferably, providing the encapsulant material comprises providing a first flowable (insulating) material. The encapsulant material may be provided on a first main surface of the at least one component. In a preferred embodiment, the method of manufacturing the component carrier comprises: providing a stack comprising at least one electrically conductive layer structure and at least one electrically insulating layer structure; providing a cavity at least partially extending in the stack; (fully) providing at least one component in the cavity and providing an encapsulant material. Said encapsulant material is provided such that during manufacturing the component carrier the encapsulant material is flowed in the cavity and thereby at least partially embedding the at least one component in the cavity. Additionally, the method of manufacturing the component carrier comprises providing a further material, said further material comprises fillers embedded therein. The further material is provided such that during manufacturing the (material of the) further material is flowed against the encapsulant material, defining with the encapsulant a boundary profile, the shape of said boundary profile being affected by the fillers.

A component carrier according to the first aspect of the present invention is created, in which a boundary profile is defined by a further material flowed against an encapsulant material. Preferably, the further material comprising a second flowable material flows against the encapsulant material comprising a first flowable material. Additionally or alternatively, the encapsulant material comprising the first flowable material may flow against the further material comprising the second flowable material. Optionally, the encapsulant material may intermingle with the further material. The fillers embedded in the further material may affect the flow behaviour of the second flowable material in that way that the second flowable material is guided and/or deflected by the fillers due to the mechanical stiffness of the fillers. Additionally or alternatively, the fillers may force the second flowable material toward the cavity which results in an increase of the reliability of the filling of the whole volume between the at least one component and the cavity. This may bring the advantage of the void-free encapsulation of the at least one component by the encapsulant material in the cavity. Furthermore, the deflection of the flow of the (second flowable material of the) further material may be forced in a direction toward the encapsulant material resulting in an intimate interaction between the further material and the encapsulant material. This may bring the advantage of a strong and a reliable interaction between the encapsulant material and the further material yielding in less delamination effects between those materials. Additionally or alternatively, the boundary profile created by the (second flowable material of the) further material against the (first flowable material of the) encapsulant material may have a non-flat topography enhancing the physical and/or chemical interaction between the aforementioned materials. This may result in a strong mechanical interaction between the encapsulant material and the further material.

In the context of the present application, the term "component carrier" may particularly denote any support structure which is capable of accommodating one or more components thereon and/or therein for providing mechanical support and/or electrical connectivity. A component carrier may also support thermal management, wherein the component carrier may in particular serve as a heat guiding and/or conduction structure, preferably supporting heat dissipation. In other words, a component carrier may be configured as a mechanical and/or electronic and/or thermal (acting) carrier for components. The component carrier may be configured to transmit electromagnetic waves.

In particular, a component carrier may be one of or may be configured as a printed circuit board (PCB), an interposer, in particular an organic interposer, and an IC (integrated circuit) substrate. A component carrier may also be a hybrid board combining different ones of the above-mentioned types of component carriers.

In some embodiments, a component carrier may in particular comprise one or more stacks and/or more than at least two electrically conductive layer structures. A component carrier may, for example, also comprise a solder resist layer structure and/or a protective layer structure. A protective layer structure may also be functionalized as an electrically conductive layer structure for at least one component. In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

In at least one embodiment, the component carrier may in particular be a laminate-type component carrier. In such an embodiment, the component carrier may in particular be a compound of multiple layer structures which are stacked one above the other and which are connected together by applying a pressing force and/or heat, in particular with simultaneous application of vacuum.

In the context of the present application, the term "printed circuit board" (PCB) may particularly denote a component carrier, in particular a plate-shaped component carrier, which is preferably formed by laminating several layer structures, for instance by applying pressure and/or by the supply of thermal energy. A PCB comprises in particular at least one insulating layer structure.

In at least one embodiment, in particular in a preferred embodiment of a PCB, the PCB is in particular formed by laminating several electrically conductive layer structures with several electrically insulating layer structures. The insulating layer structures may in particular be arranged in between the electrically conductive layer structures, wherein the electrically conductive layer structures and the insulating layer structures may be arranged alternating in stacking direction. After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

As preferred materials for PCB technology, the electrically conductive layer structures may be made of copper and/or contain at least a certain and defined amount of copper as it is well-known from prior art and usual, whereas the electrically insulating layer structures may comprise resin and/or glass fibers, so-called prepreg or FR4 material. The electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole may either connect the whole stack, (through-hole connections extending through several layers or the entire stack), or the filled hole may connect at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board may in particular be configured for accommodating one or more components on one or both opposing main surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

A dielectric part of a substrate (of an IC substrate) may be composed of resin with reinforcing particles (such as reinforcing spheres, in particular glass spheres).

In the context of the present application, the term "interposer" may in particularly denote a physical structure configured to bridge at least one electrical connection. An interposer may in particular be a physical interface layer structure. An interposer may in particular be configured to spread an electrical connection to a wider pitch and/or to bridge between different connection types. An interposer can be made of various materials, including silicon, glass, or organic substrates. An IC substrate or interposer may in particular comprise or consist of an inorganic layer structure or at least a layer of glass, silicon (Si) and/or a photo-imageable or dry-etchable organic material like epoxy-based build-up material (such as epoxy-based build-up film) or polymer compounds (which may or may not include photo- and/or thermosensitive molecules) like polyimide or polybenzoxazole as electrically insulating material.

In the context of the present application, the term "component" may particularly denote an electronic component which is configured to be mounted on and/or to be embedded into a component carrier, wherein the component may further in particular be configured to be electrically connected to the component carrier. A component can be an inorganic component (such as, for example, a semiconductor component) or a component comprising inorganic material and/or metal material and/or a combination thereof or consisting thereof.

A component may in particular be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microoptoelectromechanical system (MOEMS), a microprocessor, a capacitor, a resistor, an inductance, a battery, a switch, a camera, an antenna, a logic chip, and an energy harvesting unit. However, in addition or alternatively, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component. Additionally or alternatively, the component may comprise a polymer waveguide and/or (optical) lenses and/or collimators and/or ferrules.

In the context of the present application, the term "stack" may particularly denote an arrangement of multiple planar layer structures which are mounted in parallel on top of one another. Some of the layer structures of the stack described herein may be stacked directly onto each other, that means with not further layer structure or component in between or indirectly, wherein between other layer structures described in the present application, further layer structures or components or the like may be arranged which are not described in the present application unless explicitly described to the contrary.

In the context of the present application, the term "electrically conductive layer structure" may particularly denote a layer structure which is electrically conductive. An electrically conductive layer structure may in particular comprise one or more conductive pathways, tracks, and/or signal traces and/or through connections such as vias and holes and/or interconnection structures for interconnection of the layers and/or for connection with other elements and/or components such as bumps, pillars or the like and/or nanowires. These electrically conductive structures may for example be etched from copper sheets and may, for example, be laminated onto an electrically non-conductive or electrically insulating layer structure, which the component carrier may comprise additionally in at least one embodiment. Additionally or alternatively, the electrically conductive layer structure may be produced by an additive process, for example SAP or mSAP, wherein SAP stands for "Semi-Additive Process" and mSAP denotes the "modified Semi-Additive Process", wherein both processes SAP and mSAP are well-known from prior art. In an example, the SAP and/or mSAP may comprise acidic conditions and/or alkaline conditions.

In at least one embodiment, the at least one electrically conductive layer structure of the component carrier comprises at least one of the following group consisting of: copper, aluminum, nickel, silver, gold, palladium, molybdenum, tungsten and magnesium and/or an alloy comprising at least one material component of the aforementioned group. Although copper is usually preferred, other materials or coated versions thereof are possible as well, in particular coated with supra-conductive material or conductive polymers, such as graphene or poly(3,4-ethylenedioxythiophene) (PEDOT) or polyaniline, respectively.

In the context of the present application, the term "electrically insulating layer structure" may denote a layer structure which is electrically non-conductive. The term "electrically insulating layer structure" is in particular used as a synonym of "organic electrically insulating layer structure" in the context of the present application. Additionally or alternatively, the term "electrically insulating layer structure" may comprise an inorganic layer structure.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or sapphire and/or zirconia and/or cordierite and/or cordierite and/or steatite and/or forsterite and/or yttria and/or tungsten comprising ceramic material. Additionally or alternatively, the inorganic layer structure may comprise glass/ceramic composite material and/or non-oxide based glasses and/or glass-ceramics comprising low atomic weight elements. Yet, in another example, the inorganic layer structure may comprise semi-conducting material, for example silicon and/or germanium and/or silicon oxide and/or germanium oxide and/or silicon carbide and/or gallium nitride and/or gallium arsenide and/or indium phosphide. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above-mentioned example, such as: MoS₂, CuGaO₂, AgAlO₂, LiGaTe₂, AgInSe₂, CuFeS₂, BeO.

The at least one electrically insulating layer structure may comprise at least one of the following group consisting of: a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, (hollow) spheres or other kinds of filler particles, for example made of glass (multilayer glass) in order to form a composite, could be used as well. A semi-cured resin in combination with a reinforcing agent, for example fibers impregnated with the above-mentioned resins, is called prepreg and may also be used. These prepregs are often named after their properties for example FR4 or FR5, which describe their flame-retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating layer structures. In an example, the electrically insulating layer structure may have a thickness larger than 300 µm, in particular may be in the range from 300 µm to 1500 µm. In another example, the electrically insulating layer structure may have a thickness smaller than 300 µm, in particular in the range from 10 µm to 300 µm.

In the context of the present application, the term "layer structure" may particularly denote a continuous layer, a patterned layer or a plurality of nonconsecutive islands within a common plane. A layer structure can comprise at least one protruding element such as, for example, one or more solder bumps, copper bumps, vias, pillars or other bonding structures like these, wherein the at least one protruding element may in particular protrude beyond the surface of a layer structure.

In at least one embodiment of the present invention, at least one body and/or layer structure of the component carrier may comprise a main surface, wherein in the context of the present application, the term "main surface" of a body or a layer structure may particularly denote one of the two largest opposing surfaces of the body or the layer structure or the outermost layer (structure) of the component carriers. The main surfaces may be connected by circumferential side walls. The thickness of a body or a layer structure, such as a stack, may be defined by the distance between the two opposing main surfaces, in particular in direction perpendicular to the extension of the main surface, in particular perpendicular to its planar extension.

In the context of the present application, the term "thickness direction" or "stacking direction" may particularly refer to a direction perpendicular to a planar extension of at least one layer structure of the stack.

In the context of the present application, the term "cavity" may particularly denote a recess, a hollow space or a blind hole having been created within a structure of the component carrier, in particular in between parts and/or components and/or layers of the component carrier.

At least one cavity of the component carrier may have been created at least partially or completely by a mechanical manufacturing step, for instance by drilling and/or milling, in particular by laser drilling and/or mechanical drilling. Additionally or alternatively, an etching process may be used to create at least one cavity of the component carrier at least partially. However, material removal by laser drilling is preferred. This kind of material removal allows very precise and efficient material removal without significant introduction of mechanical stress or other significant unwanted effects into the surrounding material. Further, the resulting surface properties enable the establishment of high-quality electrical connections. In addition, laser material removal allows to handle various materials and a plurality of different cavity sizes in a very easy manner. The cavity may comprise a surface defining a bottom wall of the cavity and at least one surface defining a lateral wall of the cavity. A profile of the cavity may be defined by the surfaces defining the cavity.

In the context of the present application, the term "blind hole" may particularly denote an opening been created within a structure of the component carrier, in particular an electrically insulating layer structure. The blind hole may pass from a first main surface of the electrically insulating layer structure through the thickness of the electrically insulating layer structure along the thickness direction to the second opposed surface of the electrically insulating layer structure. The through hole may have a lateral extension being smaller than 1 mm, in particular smaller than 500 µm. Preferably, the blind hole may have a lateral extension in the range from 30 µm to 250 µm. The blind hole may comprise a first extremity being associated to the first main surface of the electrically insulating layer structure. The blind hole may have respective lateral walls and a bottom wall defining the blind hole.

In the context of the present application, the term "encapsulant material" may particularly denote a physical body configured to encapsulate at least one component. The encapsulant material may be electrically insulating. Optionally the encapsulant material may be thermally conductive in order to transmit heat away from the at least one component. The encapsulant material may be in contact with a main surface of the at least one component. Additionally, the encapsulant material may be in contact with at least one lateral wall of the at least one component. The encapsulant material may comprise material, which gets at least partially flowable when treated by heat. The encapsulant material may comprise a mechanical tamping function. The encapsulant material may comprise organic polymeric material. At least a portion of the encapsulant material may become flowable and may be provided into the cavity. The encapsulant material being at least partially flowable may be pushed by pressure into the cavity.

In the context of the present application, the term "further material" may particularly denote a physical body configured to mechanically interact with the encapsulant material. The further material may be electrically insulating. The further material may be comprised in and/or merged from an electrically insulating layer structure. The further material may be in contact with the at least one electrically conductive layer structure. The further material may comprise organic polymeric material. Preferably, at least one physical property, for example the Youngs Modulus, of the further material is different than the same physical property of the encapsulant material. According to the invention, the further material comprises fillers. The fillers may comprise inorganic material, for example metal oxides and/or metal sulfates. Preferably, the fillers comprise glass. The fillers may be in the form of fibers; additionally or alternatively, it may be in the form of particles, more in particular of spheres and/or porous particles.

In the context of the present application, the term "boundary profile" may particularly denote an interface in particular along a surface extension, recognizable between two materials of different compositions flowed one against the other, at different times, and/or with different flow rates one to each other, and/or with a chemical composition hindering the complete mixture of the two materials. According to the present invention, the "boundary profile" is preferably created between the encapsulant material and the further material. The boundary profile may be provided in close proximity to the cavity and/or may be provided inside the cavity, depending on the volume of the encapsulant material with respect of the volume remaining between the cavity and the at least one component embedded by the encapsulant. The boundary profile may comprise an irregular portion and/or a non-flat portion. Additionally, the boundary profile may comprise a flat portion. The boundary profile may extend at least partially along a vertical direction. Additionally or alternatively, the boundary profile may at least partially extend in along a horizontal direction. The boundary profile may be inclined in regard to a horizontal and/or a vertical direction.

In the context of the present application, the term "flowing" or "flowed" may particularly denote an action wherein a physical body changes or changed its position in combination with a change of its (physical) state. Thereby, the physical body may comprise a fluid-like property. The fluid-like property may be temporary during a manufacturing process step. Physical impact, for example by thermal treatment and/or exposure to forces, for example share forces and/or pressure, may change the physical property of the physical body and the physical body may become more flowable and/or gets flowing. The term flowed may describe the action of a movement of the physical body from a first position to a second portion; during said movement the physical state of the physical body is at least partially flowable. In the resulting component carrier the flowing of the materials may be recognizable by the disposition of the fillers embedded therein; for example, in case of particle fillers, the flowing of the material as a whole creates patterns and/or rows of fillers and adjacent portion with less fillers following the flowing direction.

### Description of Exemplary Embodiments

According to a preferred embodiment of the present invention, the boundary profile comprises an irregular surface. Preferably the topography of the boundary profile is non-flat. Additionally or alternatively, at least a portion of the topography of the boundary profile is flat. This may bring the advantage of ensuring a large surface area between the encapsulant material and the further material resulting in a reliable interaction between the aforementioned material. The irregular surface may be a result of an intermingling of the encapsulant material with the further material and thus this may ensure a reliable mechanical interaction between the aforementioned materials. Alternatively, the boundary profile may comprise a regular surface (portion).

According to a further embodiment, the shape of the boundary profile may be more affected by the fillers at at least one lateral area of the cavity than the shape of the boundary profile at a central area of the cavity. Preferably, the cavity is divided in a lateral area and a central area. The lateral area may be closer to a lateral wall of the cavity and the central area may be more distanced from a, in particular the same, lateral wall of the cavity. Additionally, the lateral area may circumferent the central area. Additionally, the central area may be closer to the at least one component compared to the lateral area. There may be a gap between a lateral wall of the cavity and a lateral wall of the component. The lateral area may be located above the gap. Since during manufacturing of the component carrier there may be a material-free space associated with the gap, the further material may interact with the gap and thus the fillers may affect the boundary profile to a higher extend. This may lead to a boundary profile having a more pronounced topography at at least one lateral area of the cavity and thus the interaction between the encapsulant material and the further material may be enlarged.

According to another embodiment, the encapsulant material may externally exceed the planar extension of the cavity. This may bring the advantage of enlarging the boundary profile, in particular in lateral direction compared with the area defined by the cavity. The enlarged boundary profile may ensure a reliable mechanical interaction between the encapsulant material and the further material and thus may ensure a high integrity of the stack.

According to a preferred embodiment, the encapsulant material exceeds the planar extension of the cavity of an irregular amount of said material along the cavity lateral profile. A force may be applied during manufacturing of the component carrier causing a movement of an irregular amount of the first flowable material. Said irregular amount may represent the footprint of the affection of the fillers of the further material on the boundary profile, said fillers being heterogeneously distributed in the further material resulting in a boundary profile leaving the encapsulant to flow around and beyond the cavity in an irregular manner. Due to the variable shape of the irregular amount of the first flowable material an anchor-like structure may be formed; said anchor-like structure may mechanically interact by interlocking with the further material and thus this may ensure a reliable integrity between the encapsulant material and the further material.

According to another embodiment, the encapsulant material may define bumped shapes around the cavity profile. According to a further embodiment, the bumped shapes comprise and/or define protrusion along a planar direction and/or a thickness direction. The bumped shapes may extend in a lateral direction and/or in stacking direction out of the cavity. The bumped shapes may distribute forces acting on a cavity edge and thus may enhance the integrity of the stack.

According to a preferred embodiment, the encapsulant material comprises at least one portion, in particular a plurality of portions, contacting a main surface of a structure, in particular the at least one electrically insulating layer structure, delimiting the cavity. The encapsulant material may have a reliable interaction with the structure, in particular the at least one electrically insulating layer structure, and thus may reduce the phenomenon of delamination.

According to a further embodiment, the boundary profile may comprise a first portion and a second portion, said first portion is closer to a central area of the at least one component in comparison to the second portion and the first portion is less affected by the fillers than the second portion. Close proximity of the at least one component associated to the first portion of the boundary profile may result in less affection of the shape of the boundary profile induced by the fillers of the further material. Nevertheless, the first portion of the boundary profile may comprise an irregular topography ensuring a reliable interaction between the encapsulant material and the further material. A transition from the first portion into the second portion may ensure an interaction between the encapsulant material and the further material, wherein between the encapsulant material and the further material there are no voids provided.

According to another embodiment, the fillers may comprise a plurality of fibers. According to a further embodiment, the plurality of fibers may be configured to form a woven textile embedded in the further material. Fibers may impart physical properties to the further material. For example, the mechanical strength may be increased in at least on planar direction. By creating a woven textile out of the fibers, the change of the mechanical strength may be further increase. Additionally, the further material may have increased physical properties in at least two (lateral) directions.

According to a preferred embodiment, the plurality of fibers are configured to form a plurality of warps and wefts. By forming warps and wefts the physical and/or mechanical properties of the fibers can be easily adapted for example by choosing the amount of warps and wefts per a defined area-unit, for example square-mm.

According to another embodiment, the plurality of fibers, in particular the plurality of warps and wefts, may affect the exceeding of the encapsulant material beyond the planar extension of the cavity. The presence of warps and wefts may hinder the second flowable material from loosely flowing and thus may adjust the amount of the second flowable material to be flowed in a lateral direction.

According to a further embodiment, the extension of the plurality of fibers, in particular of the formed woven textile, may change along the thickness direction of the stack along a planar extension of the cavity. The extension of the woven textile may be defined by the median plane with respect to two planes oppositely following the external footprint along the thickness of the woven textile, in particular said two planes being in contact and/or tangent to the warps and wefts of said woven textile. The position of fibers may raise or drop in regard to thickness direction. Additionally or alternatively, the change of the fibers may repeat in a cyclic manner. For example, the fibers may have a sine wave shape. According to a preferred embodiment, the position of the fillers changes along a wave-shaped extension in regard to a cross-sectional view. According to another embodiment, at least one protrusion resulting from the wave-shaped extension may be closer to the internal of the cavity than protrusions or valleys of other portions of the wave-shaped extended fillers. The affection of the shape of the boundary profile may depend on the shape, for example sine wave shape, of the fibers. By choosing a proper shape of the fibers, and/or the proper flowability of the further material (for example the curing degree of a resin composing the further material), the shape of the boundary profile may be adjusted accordingly. This may bring the advantage of defining the shape the boundary profile accordingly and boundary profile having a more pronounced topography may be created.

According to an embodiment, at least one protrusion, at a central planar portion of the cavity, resulting from the wave-shaped extension, may be closer to the internal of the cavity in regard to stacking direction with respect to at least a further protrusion provided more peripherally. Due to a more pronounced protrusion the interfacial area between the further material and the encapsulant material may be increased compared to a flat interface between the further material and the encapsulant material and thus the mechanical interaction between the two aforementioned materials is ensured.

According to a further embodiment, the vertical extension of the fillers may be affected by the presence of the at least one component embedded in the cavity. At least a portion of the fillers may overlap with the at least one component in regard to a planar view. For example, the boundary profile may be less affected by the at least one component in close proximity to the fillers. The boundary profile in close proximity to the at least one component may be flatter. Nevertheless, the topography of the boundary profile in close proximity to the at least one component may be structured in a suitable manner to ensure a mechanical interaction between the encapsulant material and the further material.

According to another embodiment, the fillers overlapping with the cavity and not overlapping with the component embedded in the cavity may be more protruding into the cavity than the filler overlapping with the component. The fillers may be pushed into a gap provided between a lateral wall of the cavity and a lateral wall of the component. This may create a more uneven topology of the boundary profile and thus increase the mechanical interaction between the encapsulant material and the further material. For example, a valley of the wave shaped fiber may be located in the gap, which may cause a pronounced indentation in the boundary profile.

According to a preferred embodiment, the boundary profile has a vertical distance from the fillers that is variable within the respective surface extension. Due to variable fibers position, in particular position of warps and wefts, in regard to thickness direction, the boundary profile may have a variable distance to the fibers within the respective surface extension. Additionally or alternatively, the vertical position of the fillers may vary due to the sine wave shape of the fillers. A close vertical distance from the fillers to the boundary profile may indicate that the boundary profile is highly affected by the fillers. The variable distance from the filler to the boundary profile may locally change the physical and/or mechanical properties at the boundary profile. A locally enhanced stiffness of the boundary profile in close proximity to the cavity may better distribute forces applied to the cavity and thus may increase the integrity of the stack.

According to another embodiment, the shape of the boundary profile is more affected by the presence of the at least one component than the corresponding overlapping fillers. The at least one component may mechanically act as a big filler. Therefore, the impact of the at least one component on the boundary is more pronounced than the impact of the filler on the boundary profile. A less pronounced boundary profile associated to the at least one component may be beneficial in terms of precise positioning of the at least one component in the cavity. Additionally a reliable connection to the at least one component passing through the boundary profile may be ensured, when a via connection is formed through the encapsulant material and the further material, since the process of forming the via connection can be easily applied at a portion of the boundary profile having a less pronounced topography.

According to a further embodiment, the boundary profile may comprise a wave-like shape extension in regard to a cross-sectional view, in particular a variable wave-like shape within the respective surface extension. A wave-like shape (extension) may comprise a cyclic repeating unit. The wave-like shape may comprise at least one valley and at least one peak. Additionally or alternatively, the wave-like shape (extension) may comprise at least one indentation and at least one protrusion. Due to an overall wave-like shape of the boundary profile, the surface area may be increased in comparison with a (horizontally) flat boundary profile. This may enhance the mechanical interaction between the encapsulant material and the further material.

According to a preferred embodiment, the wave-shape extension of the boundary profile is at least partially different from the wave-shape extension of the fillers. In an example, the amplitude and/or the frequency of the wave-shape extension of the boundary profile may be different from the wave-shape extension of the fillers. According to another embodiment, the difference of the wave-shape extension of the boundary profile and the wave-shape extension of the fillers may comprise different heights in regard to stacking direction. According to a preferred embodiment, the difference of the wave-shape extension of the boundary profile and the wave-shape extension of the fillers comprises offset wave evolutions. According to an embodiment, the difference of the wave-shape extension of the boundary profile and the wave-shape extension of the fillers may comprise valley and peaks of the respective waves offset one to each other. Additionally or alternatively, the wave-shape extension of the boundary profile may be phase shifted from the wave-shape extension of the fillers. The different wave-shape extension between the boundary profile and the fillers is the footprint of the balance of the viscosity of the two materials (encapsulant material and the further material) during the respective flowing, causing forces resulting in different shapes than those naturally formed by the fillers alone. The wave-shape extension of the boundary profile may be directly impacted by the wave-shape extension of the fillers. Alternatively, the wave-shape extension of the boundary profile may be indirectly impacted by the wave-shape extension of the fillers. Preferably, the wave-shape extension of the fillers may impart its shape to the second flowable material of the further material. Due to the composition of the further material, the wave-shape extension may be modified and the modified wave-shape extension may be provided to the boundary profile. The different wave-shape extension of the boundary profile compared with the wave-shape extension of the fillers may distribute forces (compare with the phenomenon of a destructive interference); this may enhance the mechanical interaction between the encapsulant material and the further material. Alternatively, the wave-shape extension of the boundary profile may be the same as the wave-shape extension of the fillers.

According to another embodiment, at least a portion of the boundary profile may follow the external footprint of the warps and wefts. This can be the case wherein (a portion of) the boundary profile is less affected by the flowing materials interaction, and then more by the fillers. Due to the geometry of warps and wefts, the boundary profile may extend in two directions, in particular orthogonal directions. The boundary profile may have a kink in regard to a planar view. Thus, the boundary profile may be enforced in two lateral directions.

According to another embodiment, at least a portion of the boundary profile following the external footprint of the warps and wefts may protrude towards internal of the cavity and/or the component. The boundary profile may protrude into a corner of the cavity. This may stability the cavity at the corners especially when external forces are acting of the cavity.

According to a preferred embodiment, a portion of the encapsulant material extends through the thickness of the further material forming at least one bulge protrusion. This extension may depend to the specific position and/or concentration of the fillers in the further material and/or of the viscosity status at the place of the bulge protrusion (i.e. in which the viscosity of the further material is consistently higher than that of the encapsulant material). The at least one bulge protrusion may vertically mechanically interconnect the further material and the encapsulant material. This may mechanically interconnect the encapsulant material and the further material and thus may reduce delamination between the encapsulant material and the further material.

According to a further embodiment, the curing temperature of the further material may be higher than the curing temperature of the encapsulant material. Preferably, the curing temperature of the second flowable material is higher than the curing temperature of the first flowable material. The encapsulant material may be flowable at lower temperatures and thus may reliably embed the at least one component. Thereby, the encapsulant material may get flowable and flows from a top main surface of the at least one component to a lateral wall of the component. Preferably the at least one component may be embraced by the encapsulant material. The further material may become flowable at higher temperatures and thus may form an interaction with the encapsulant material. Thereby, a reliable interconnection between the encapsulant material, the further material and the at least one component may be formed.

According to another embodiment, the at least one electrically conductive layer structure may be provided on a main surface of a layer structure delimiting the cavity, said at least one electrically conductive layer structure being configures as a stop layer deliming the flowing of the encapsulant material flowed from the cavity. Preferably, the layer structure delimiting the cavity is provided at a top extremity of the cavity. The at least one electrically conductive layer structure may be precisely structure, for example by an etching process step. Thus, the delimitation of the cavity may be precisely structured and/or positioned. This may further affect the shape of the boundary profile, especially in lateral direction. Alternatively, another electrically insulating layer structure may be provided on a main surface of a layer structure deliming the cavity.

According to a preferred embodiment, the at least one electrically conductive layer structure is configured as a stepped structure encircling the external profile of the cavity. Due to the stepped structure, preferably located at the top extremity of the cavity, an additional lateral portion in the cavity is provided with which the encapsulant material can mechanically interact in combination with the further material. Preferably, the stepped structure has a thickness according to the thickness of the layer structure delimiting the cavity, for example the at least one electrically conductive layer structure. The thickness of the stepped structure may be smaller than the thickness of the cavity. This thickness difference may result in a difference of the boundary profile associated to the stepped structure compared with the boundary profile associated to the rest of the cavity. Preferably, the topography of boundary profile associated to the stepped structure may be less pronounced compared with the topography of the boundary profile associated to bulk of the cavity. There may be a transition of the boundary profile in regard to a portion of the stack not being associated to the cavity via the boundary profile in regard to a portion of the stack associated to the stepped structure to the boundary profile in regard to a portion of the stack associated to the cavity.

According to a further embodiment, the boundary profile may comprise a plurality of recesses and a plurality of protrusions, said protrusions extending toward the internal of the cavity. The plurality of recesses and the plurality of protrusions may be related to the topography of the boundary surface. A recess may be provided next to a protrusion. Alternatively, a recess may be provided laterally next to another recess. Additionally, a protrusion may be laterally provided next to another protrusion. According to an embodiment, the plurality of recesses and the plurality of protrusions may follow the contour of the at least a portion of the plurality of fibers. According to another embodiment, a first recess and/or a first protrusion may be smaller than a second recess and/or a second protrusion. According to a preferred embodiment, the first recess and/or the first protrusion is in closer proximity to the at least one component than the second recess and/or the second protrusion. The extend in thickness direction of a recess and/or a protrusion may be affected by the existence of the at least one component (in close proximity). The plurality of recesses and plurality of protrusions may form the boundary profile. The more pronounced the recesses and/or the protrusions the higher the physical and/or machinal interaction between the encapsulant material and the further material.

According to another embodiment, at least a portion of the boundary profile overlapping with the at least one component in regard to a cross-sectional view may be free of irregularities. A main surface of the boundary profile may be parallel to a main surface of the stack. According to an embodiment, at least a portion of the fibers comprise an extension being substantially parallel with a main surface (of a layer structure and/or the stack). This may result in at least a portion of the boundary profile overlapping with the at least one component in regard to a cross-sectional view being free of irregularities. A portion of the boundary profile being flat and/or being free from irregularities may bring the advantage of creating the boundary profile regularly composed of the encapsulant material and of the further material above the component, resulting in distributed forces and CTE behaviors above it.

According to another embodiment, at least a portion of the boundary profile overlapping with the at least one component along a cross-sectional view is free of irregularities in proximity of the cavity profile. The portion of the boundary profile overlapping with the component in proximity of the cavity profile may comprise less irregularities than the portion of the boundary profile overlapping with the at least one component in the center of the cavity. In an example, the portion of the boundary profile overlapping with the at least one component along a cross-sectional view being free of irregularities in proximity of the cavity profile may be in a range from 1 µm 30 µm. A portion of the boundary profile being flat and/or being free from irregularities may be the outcome of the affection of the cavity profile to the boundary profile. In the context of the present application, the term "free of irregularities" may particularly denote a surface profile having small protrusions and/or indentations. In an example the protrusions and/or indentations may be smaller than 5 µm, in particular in the range from 50 nm to 5 µm. Preferably, the boundary profile overlapping with the at least one component along a cross-sectional view is free of irregularities may be substantially flat and/or extend in a horizontal direction.

According to a further embodiment, the encapsulant material externally exceeding the planar extension of the cavity may comprise a planar extension parallel to a main surface of at least one of the structures composing the stack. In an example, the main surface of the at least one of the structures composing the stack being parallel to the encapsulant material externally exceeding the planar extension of the cavity may be in direct contact with the structures composing the stack. Additionally or alternatively, the main surface of the at least one of the structures composing the stack being parallel to the encapsulant material externally exceeding the planar extension of the cavity may face away from the structures composing the stack. Preferably, the at least one of the structures composing the stack is the at least one electrically insulating layer structure in which the cavity is provided. This may bring the advantage of reliably and precisely stacking the encapsulant material and the further material one above the other in stacking direction. In an example, the encapsulant material exceeding the planar extension of the cavity may be in the range from 1 µm to 30 µm in regard to a lateral direction. In another example, the encapsulant material exceeding the planar extension of the cavity may be in the range from 1 µm to 5 µm in regard to stacking direction.

According to another embodiment, the encapsulant material externally exceeding the planar extension of the cavity may comprise a constant thickness. This may bring the advantage of mechanically interlocking the encapsulant material and the further material.

According to a preferred embodiment, the encapsulant material externally exceeding the planar extension of the cavity comprises an external surface facing away (along the stacking direction) from the cavity having a rounded and/or irregular profile. A rounded profile and/or an irregular profile may comprise larger surface areas in comparison to flat and/or rectangular profiles and thus this may increase the physical and/or mechanical interaction between the encapsulant material and the further material.

According to a further embodiment, the encapsulant material externally exceeding the planar extension of the cavity may comprise a variable thickness. According to another embodiment, the encapsulant material externally exceeding the planar extension of the cavity may comprise an irregular planar extension. The encapsulant material externally exceeding the planar extension of the cavity comprising a variable thickness and/or an irregular planar extension may increase the surface area between the encapsulant material and the further material and thus the physical interaction between the aforementioned material is increased.

According to a preferred embodiment, the encapsulant material externally exceeding the planar extension of the cavity encircles at least partially, in particular completely, the cavity (in regard to a planar view). This may distribute forces acting on the cavity in a reliable manner since the forces may act on the encapsulant material externally exceeding the planar extension of the cavity. This may hinder the forces acting on the inner of the cavity and thus this may result that less forces are acting on the at least one component embedded in the cavity.

According to another embodiment, the encapsulant material externally exceeding the planar extension of the cavity may comprise a thickness having a value less than 5 times the value of the thickness of the flowed material on and above the at least one component. Preferably, the flowed material on and above the at least one component comprises the first flowable material. This may ensure that the flowed material is in close proximity to the cavity and thus may ensure that the beneficial effect described above are related to a portion of the stack in close proximity to the cavity.

According to a further embodiment, the encapsulant material inside the cavity may define an irregular surface facing the further material. The boundary profile may comprise the irregular surface facing the further material. The irregular surface may comprise a portion of the interface between the further material and the encapsulant material. Preferably, the irregular surface may be laterally provided between a lateral wall of the cavity and a lateral wall of the at least one component. In an example, the irregular surface may extend in a horizontal direction. In another example, the irregular surface may extend in a vertical direction. The irregular surface provided inside the cavity may result from the circumstance the further material protrudes inside the cavity. This may bring the advantage of reliably embedding the at least one component inside the cavity. Additionally, the further material may mechanically interlock with at least one electrically insulating layer structure, since the further material is in contact with a main surface of the at least one electrically insulating layer structure and a lateral wall of the at least one electrically insulating layer structure defining the cavity.

According to a preferred embodiment, the encapsulant material has substantially the same volume as the volume inside the cavity with the inserted at least one component. In the context of this application the term "substantially the same" may include a deviation of maximum 10%. Preferably, the volume of the encapsulant material has a deviation in the range from 1% to 5% from the volume inside the cavity with the inserted component. According to another embodiment, the encapsulant material may have a greater volume, in particular at least 1% greater, than the volume inside the cavity with the inserted component. This may bring the advantage of selectively and fully filling the volume of the cavity while at the same time saving resources in terms of material.

According to another embodiment, the encapsulant material may have a smaller volume than the volume inside the cavity with the inserted at least one component. Preferably, the remaining volume not being filled by the encapsulant material and the inserted component may be filled by the further material, in particular the second flowable material. This may result in that the boundary profile is provided inside the cavity. The at least one component may be fully and/or void-free embedded by the encapsulant material and the further material.

According to a further embodiment, a plurality of components may be provided in the cavity. This may enlarge the functionality of the component carrier.

According to a preferred embodiment, the plurality of components is distributed within the planar extension of the cavity. According to another embodiment, the plurality of components may be provided in the cavity in a patterned distribution. Preferably, the plurality of components may be arranged in a matrix, for example a 2 by 1 matrix or a 2 by 2 matrix. According to a further embodiment, the plurality of components may be provided in the cavity forming rows and/or columns of components aligned parallel one to each other. A distribution of a plurality of components within the planar extension of the cavity may increase the density of functionality inside the cavity. This may also allow a short connection if at least two of the plurality of the components are electrically interconnected with each other.

According to another embodiment, the further material may be provided by a planar pushing element. This may bring the advantage of aligning the further material parallel to a main surface of the at least one electrically insulating layer structure and/or the main surface of the bottom of the cavity.

According to preferred embodiment, the planar pushing element remains attached to the flowed material of the encapsulant material. This may bring the advantage of reducing the risk of implementing foreign material in the stack, since the planar pushing element may be an element of the stack.

According to another embodiment, the planar pushing element may be a rigid body. This may simplify the manufacturing process of the component carrier since handling and/or manipulating of rigid bodies is straight forward.

According to a further embodiment, the planar pushing element may be a layer. Preferably, the planar pushing element may comprise the further material and/or the at least one electrically insulating layer structure. This may simplify the construction of the stack, since the layers and/or the further material may be applied on top of each in an easy manner.

According to a preferred embodiment, the planar pushing element comprises curable material. Preferably, the planar pushing element comprises an organic and/or a polymeric material. This may bring the advantage of reliably connecting the planar pushing element to the stack, since during manufacturing the planar pushing element gets pushed onto the stack and interconnects with the stack by a curing reaction.

According to another embodiment, the planar pushing element may be fully cured, in particular during or after the flowing of the flowable material of the encapsulant material. This may bring the advantage of enhancing the mechanical stability of the planar pushing element, especially when the planar pushing element remains attached to the flowed material of the encapsulant material, since fully cured material have a high Youngs Modulus and/or tensile strength.

According to a further embodiment, the planar pushing element may form the boundary profile with the encapsulant material. Preferably, the boundary profile may be created by intermingling the planar pushing element with the encapsulant material. This may bring the advantage of precisely providing the boundary profile in regard to a planar direction since the planar pushing element can by placed with a deviation of 1 µm to 10 µm in a lateral direction.

According to a preferred embodiment, the boundary profile formed by the planar pushing element has an irregular surface. The irregular surface of the boundary profile may increase the surface area between the planar pushing element and the encapsulant material in comparison with the flat surface and thus this may result in a reliable mechanical interaction between the planar pushing element and the encapsulant material.

According to another embodiment, the planar pushing element may comprise in organic material. According to an embodiment, the planar pushing element may comprise the further material. Preferably, the planar pushing element comprises similar material properties as the encapsulant material. Since the encapsulant material also comprises an organic material, an enhanced adhesion may be ensured due to the similar material properties of the different materials.

According to a further embodiment, the fillers, in particular the fibers, of the planar pushing element may be (fully) embedded in the planar pushing element, in particular in the organic material. According to a preferred embodiment, the fillers, in particular the fibers, of the planar pushing element may affect the shape of the boundary profile. The fillers, in particular the fibers, may be provided (simultaneously) with the planar pushing element and thus the boundary profile between the encapsulant material and the planar pushing element may be affected. This may simplify the manufacturing process of the component carrier since the provision of the fillers and the planar pushing element are done within one process step.

According to a preferred embodiment, a plurality of encapsulant materials is provided on the respective components. This may bring the advantage of reliably embedding each respective component. This may ensure that a main surface of each of the respective components is in contact with an encapsulant material, in particular one of the plurality of encapsulant material.

According to a further embodiment, an adhesive material may be provided in the cavity, in particular at the bottom of the cavity. This may bring the advantage of fixing the at least one component in the cavity by the adhesive material.

According to another embodiment, the method may further comprise providing a further material on the encapsulant material, said further material comprises fillers embedded therein. Preferably, the further material comprises the second flowable material. This may ensure of reliably encapsulating the at least one component. Additionally or alternatively, this may fully fill the cavity.

According to a further embodiment, the method further may comprise forming a boundary profile defined by flowing the encapsulant material and the further material against each other, so that the fillers of the further material affects the shape of the boundary profile. The boundary profile may be a result of an intermingling of the encapsulant material with the further material and thus this may ensure a reliable mechanical interaction between the aforementioned materials. This may bring the advantage of reliably and/or strongly interconnecting the encapsulant material and the further material, especially the first flowable material of the encapsulant material with the second flowable material of the further material.

According to another embodiment, the method further may comprise providing the further material in direct contact with the at least one electrically conductive layer structure and/or the electrically insulating layer structure and/or the encapsulant material. This may ensure that the respective elements of the stack mechanically interlock with each other. This may enhance the integrity of the stack.

According to a further embodiment, the method further may comprise providing the further material in the cavity. The further material may be in direct contact with the encapsulant material and the at least one electrically insulating layer structure. Additionally or alternatively, the further material may be provided between the at least one electrically insulating layer structure defining a lateral wall of the cavity and the encapsulant material. This may bring the advantage of fully filling the cavity in case if the encapsulant material did not fill the cavity completely.

According to a preferred embodiment, the step of flowing the encapsulant material is configured so that the encapsulant material flows first on the surface of the at least one component on which the encapsulant material is provided, and secondly (afterwards) in a space (and/or a gap) between a lateral wall of the cavity and a lateral wall of the at least one component filling said space. This may ensure that the at least one component is encapsulated be the first flowable material on a main surface of the at least one component and at a lateral wall of the at least one component. This may bring the advantage of the placement of the encapsulant material on one side of the (at least one) component, preferably that facing the aperture of the cavity, to then embed the other sides of the components.

According to another embodiment, the step of flowing the encapsulant material may be configured so that the encapsulant material flows on a second main surface of the at least one component. The choice of the suitable amount of encapsulant material and/or of the material with the proper flowability and/or of the due interspaces between the cavity and the at least one component, may ensure that the at least one component is encapsulated on both opposed main surfaces and a lateral wall. This may result in a fully embedded component.

According to a further embodiment, the step of flowing the encapsulant material may be configured so that the encapsulant material flows such that a portion of the flowable material fills a space (and/or a gap) between the second main surface of the at least one component and a main surface defined by the cavity. Preferably the space and/or the gap is provided at the bottom of the cavity. The encapsulant material may flow from the top main surface of the at least one component over a lateral wall of the at least one component to a space and/or a gap between the second main surface of the component and a main surface defined by the cavity. The space and/or gap may be created due to at least one connection terminal protruding from the component and thus a main surface of the at least one component is spaced from the bottom wall of the cavity. This may bring the advantage of reliably filling the cavity even if a main surface of the at least one component is not in direct contact with the bottom of the cavity.

According to a preferred embodiment, the encapsulant material is provided on top of the at least one component only. The encapsulant material may be provided on a first main surface of the at least one component only. The encapsulant material may be provided on top of the at least one component before a lamination process step and/or a provision of heat. This may ensure an easier and precise positioning of the encapsulant material. Additionally or alternatively, the volume of encapsulant material may be controlled after the provision of it.

According to another embodiment, the encapsulant material before the flowing of the respective material inside the cavity may have a planar extension smaller than the planar extension of the cavity. This may bring the advantage of an easier placement of the encapsulant material, without the need is precise methods, providing the encapsulant material in the cavity only without providing the encapsulant material on a main surface of the at least one electrically insulating layer structure.

According to a further embodiment, the encapsulant material before the flowing of the respective material inside the cavity has a planar extension smaller than the planar extension of the at least one component. This may ensure that the encapsulant material is provided on a main surface of the at least one component without flowing and/or dripping over a lateral wall of the at least one component.

According to a preferred embodiment, the encapsulant material after the flowing of the respective material inside the cavity has a planar extension equal or greater than the planar extension of the cavity and/or the at least one component. In an example, the encapsulant material may flow in one lateral direction. In another example, the encapsulant material may flow in two lateral directions. This may ensure that the space and/or the gap provided between the lateral wall of the (at least one) component and the lateral wall of the cavity is filled by the encapsulant material. This may bring the advantage of reliably embedded the at least one component in the stack. This manufacturing process step may create the product feature wherein the encapsulant material define bumped shapes around the cavity profile.

According to another embodiment, the encapsulant material after the flowing of the respective insulating material inside the cavity may define a portion external to the cavity (in regard to a top view). This manufacturing process step may create the product feature wherein the encapsulant material externally exceeds a planar extension of the cavity. This may bring the advantage of ensuring that the volume of the cavity is fully filled. The encapsulant material exceeding the cavity may be an indicator that cavity is fully filled. Additionally, the encapsulant material externally exceeding the cavity may provide additional advantageous mechanical features as described above.

According to a further embodiment, the provision of the encapsulant material on the component may be provided after the insertion of the at least one component inside the cavity. This may ensure an easier placement of the encapsulant material, to be inserted in the volume of the cavity above the at least one component; during a lamination process step the encapsulant material cling to the surface of the at least one component, especially on a main surface of the at least one component and on a lateral wall of the at least one component. This may ensure a reliable mechanical interaction between the at least one component and the encapsulant material. Alternatively, at least a portion of the encapsulant material on the at least one component may be provided before the insertion of the at least one component inside the cavity.

According to a preferred embodiment, the flowing of the material of the encapsulant material inside the cavity embedding the at least one component is performed in a vacuum environment. A vacuum environment may ensure that the cavity is void-free filled may the encapsulant material and optionally the further material.

According to a further embodiment, the flowing of the encapsulant material may be realized by a pressure of a planar pushing element. The planar pushing element may provide the encapsulant material and optionally the further material by application of pressure into the cavity. The viscosity of the encapsulant material and/or the further material may be reduced by the application of force in form of pressure and thus this may ensure a void-free filling of the cavity.

According to another embodiment, the planar pushing element may be provided temporarily. The planar pushing may act as an aid-tool in order to provide the further material. After at least one process step the planar pushing element may be removed.

According to a preferred embodiment, the material of the encapsulant material is flowed by imparting mechanical and/or thermal energy to the encapsulating material. According to another embodiment, the material of the further material may be flowed by imparting mechanical and/or thermal energy to the further material. According to further embodiment, the method of manufacturing the component carrier may comprise a lamination process step. Since the encapsulant material and/or the further material may comprise organic polymeric material and/or the first flowable material or the second flowable material, the viscosity of the related materials may be decreased by a lamination process step and/or the provision of mechanical and/or thermal energy which simplifies the encapsulation of the at least one component inside the cavity by the respective materials.

According to a preferred embodiment, the method of manufacturing the component carrier further comprises bringing the encapsulant material in a flowable state and afterwards bringing the further material in a flowable state. This may bring the advantage of embedding the at least one component by the encapsulant material and afterwards circumventing the encapsulant material by the further material. This may be beneficial since the encapsulant material may have a mechanical damping effect which reduces forces acting on the at least one component.

According to another embodiment, the method of manufacturing the component carrier may further comprise providing an adhesive material in the cavity, in particular at the bottom of the cavity. According to a further embodiment, the method of manufacturing the component carrier may further comprise providing the adhesive material in the cavity such that the insertion of the at least one component in the cavity comprises the fixation of the at least one component in the cavity through the adhesive material. This may bring the advantage of locally fixing the at least one component at the bottom of the cavity, which enhances the precision of the manufacturing process.

According to an embodiment, at least one body may comprise said encapsulant material and/or the further material. According to a preferred embodiment, the step of providing the encapsulant material on the at least one component comprises the provision of said at least one body on the at least one component. Preferably the body may be in solid state. This may bring the advantage of precisely placing a dedicated amount of encapsulant material and/or the further material on top of the at least one component; in particular a respective body comprising the encapsulant material and/or the further material may be positioned on a respective component. Due to the manufacturing process the at least one body may be provided in a precise manner on at least one component. Additionally or alternatively, the at least one body may comprise a bridge component, an interposer and/or an IC substrate. The at least one body may in direct contact with at least one of the plurality of the components. Additionally or alternatively, the at least one body may in indirect contact with at least one of the plurality of the components. This may bring the advantage that the body is in close proximity to the at least one component and thus a signal may be forwarded in a fast manner. Alternatively, the body may be a physical body comprising the encapsulant material and/or the further material.

According to an embodiment, a plurality of components may be inserted in the cavity, and in particular the step of providing the encapsulant material on the component may comprise the provision of at least one body on the one or the plurality of components. This may bring the advantage of distributing the encapsulant material to a dedicated portion of the cavity (in regard to a lateral extension), especially before the flowing of the encapsulant material. This may ensure that the at least one component is encapsulant reliably, since the encapsulant material after flowing inside the cavity may flow on or over at least two lateral walls of a respective component.

According to a further embodiment, the step of providing the encapsulant material on the component may comprise the provision of a plurality of bodies comprising the encapsulant material on the at least one component, in particular said plurality of bodies on the at least one component being connected one to each other by at least one connection structure. Preferably, this may be done before flowing the encapsulant material inside the cavity at least partially embedding the at least one component. This may bring the advantage of spreading the encapsulant material on the at least one component in regard to at least one, in particular two, lateral directions. This may ensure that all lateral walls of the at least one component are in direct contact with the encapsulant material and thus a reliable embedding of the component is ensured.

According to another embodiment, the method of manufacturing the component carrier may further comprise connecting the plurality of encapsulant materials one to each other by at least one connection structure. In an example, at least one of the encapsulant material may comprise the at least one connection structure. Preferably, the at least one connection structure may comprise similar, in particular the same, material as the encapsulant material. This may bring the advantage of connection the plurality of encapsulant material with each other. Additionally or alternatively, the volume laterally between the respective components may be reliably filled by the at least one connection structure.

According to a preferred embodiment, the method of manufacturing the component carrier further comprises a plurality of bodies on the at least one component being connected through at least one connection rib, in particular such that the at least one connection rib planarly extending between at least two of the plurality of components. According to a further embodiment, the method of manufacturing the component carrier may further comprise providing at least one connection rib between the plurality of encapsulant materials such that the at least one connection rib planarly extends between at least two of the plurality of components. Preferably, at least two, in particular at least four, components are connected one to each other may the at least once connection rip. This may ensure that plurality of components is connected one to each other by (only) one material. The connection rib may comprise similar, in particular the same, material as the encapsulant material. Optionally, the connection rib and/or the at least one connection structure may comprise material being different than the material of the encapsulant material, in particular the first flowable material.

According to an embodiment, the method of manufacturing the component carrier may further comprise providing the encapsulant material and/or the plurality of encapsulant materials such that a frame structure from a top view is formed. According to another embodiment, the frame structure may be configured to be inserted in the cavity before the respective further material. Preferably, the frame structure may circumferent the at least one component, in particular at least two components, more in particular all of the plurality of components. The frame structure may mechanically protect the at least one component from external forces provided to the stack. In an example, the frame structure may comprise the at least one connection rib and/or the at least once connection structure.

According to a preferred embodiment, the method of manufacturing the component comprises providing the at least one connection structure and/or the at least one connection rib and/or the frame structure by providing the at least one body. The at least one body may be a pre-manufactured element. Providing the at least one connection structure and/or the at least one connection rib and/or the frame structure by providing the at least one body may be advantageous since the body may be checked by an inspection tool in advance before the provision of the body to the stack. This may ensure that an exact volume/amount and/or shape of encapsulant material and/or further material may be provided and thereby nicely fitting into the cavity.

The preferred embodiments presented with reference to a component carrier according to the first aspect of the present invention and its advantages apply correspondingly to a method according to the second aspect of the present invention.

Further features of the invention are shown in the claims, the figures, and the description of the figures. All the features and combinations of features mentioned above in the description as well as the features and combinations of features mentioned below in the description of the figures and/or shown alone or in combination in the figures can be used not only in the combination as indicated or shown in each case, but also in other combinations or on their own so far it can technically be realized.

### Brief Description of the Drawings

The aspects defined above and further aspects of the invention are apparent from the examples of embodiment to be described hereinafter and are explained with reference to these examples of embodiment.
Figure 1A to Figure 1F illustrate cross-sectional views of structures obtained during carrying out a first method of manufacturing a component carrier according to an exemplary embodiment of the invention.
Figure 2A to Figure 2G illustrate cross-sectional views of structures obtained during carrying out a second method of manufacturing a component carrier according to an exemplary embodiment of the invention, for example like the embodiment shown in Figure 9.
Figure 3 illustrates cross-sectional view of a component carrier according to an exemplary embodiment of the invention.
Figure 4 illustrates a top view of a preform of a component carrier according to an exemplary embodiment of the invention.
Figure 5 illustrates a top view of a preform of another component carrier according to an exemplary embodiment of the invention.
Figure 6 shows a microscopic image of a cross-section view of a component carrier according to an exemplary embodiment of the invention.
Figure 7 shows a microscopic image of a cross-section view of a component carrier according to an exemplary embodiment of the invention.
Figure 8 shows a microscopic image of a cross-section view of a component carrier according to an exemplary embodiment of the invention.
Figure 9 shows a microscopic image of a cross-section view of a component carrier according to an exemplary embodiment of the invention.
Figure 10 shows a microscopic image of a cross-section view of a component carrier according to an exemplary embodiment of the invention.
Figure 11 shows a microscopic image of a cross-section view of a component carrier according to an exemplary embodiment of the invention.
Figure 12 shows a microscopic image of a cross-section view of a component carrier according to an exemplary embodiment of the invention.
Figure 13 shows a microscopic image of a cross-section view of a component carrier according to an exemplary embodiment of the invention.

### Detailed Description of the Drawings

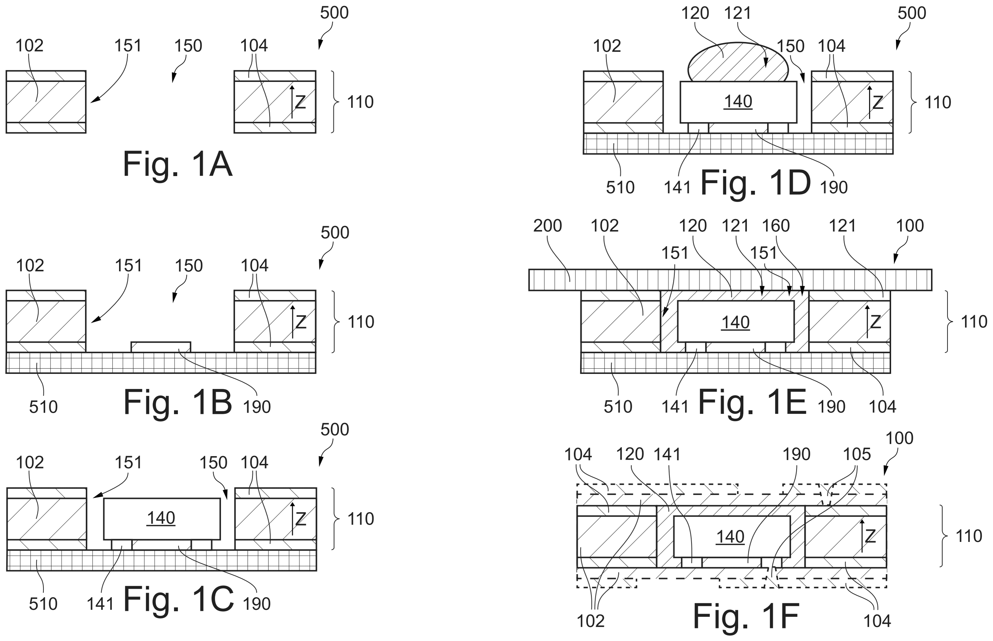

Figure 1A shows a cross-sectional view of a preform of a component carrier 500 as an exemplary embodiment of the present invention. The preform of the component carrier 500 comprises an electrically insulating layer structure 102. Preferably, the electrically insulating layer structure 102 comprises an organic polymeric material, for example an epoxy resin and/or a poly (meth)acrylate. Additionally or alternatively, the electrically insulating layer structure 102 may comprise inorganic material, for example glass, glass ceramic and/or ceramic, and/or may comprise an inorganic layer structure. Optionally, the electrically insulating layer structure 102 may comprise reinforcement material, for example glass spheres and/or glass fibers. The electrically insulating layer structure 102 may be configured as a core structure. Two electrically conductive layer structure 104 are provided on the electrically insulating layer structure 102. A first respective electrically conductive layer structure 104 is provided on a first main surface, for example the top surface, of the electrically insulating layer structure 102 and a second electrically conductive layer structure 104 is provided on a second main surface, for example the bottom surface, of the electrically insulating layer structure 102. The respective electrically conductive layer structures 104 may comprise a metal, for example copper, in particular a copper foil. The electrically insulating layer structures 102 sandwiched between the two electrically conductive layer structure 104 in regard to stacking direction Z and the two electrically conductive layer structures 104 may form a stack 110. Optionally, the electrically conductive layer structures 104 may be patterned or removed, for example by using an etching process step. A cavity 150 is provided in the stack 110 extending from a main surface to an opposed other main surface. The cavity 150 may be composed as a through cavity. Thereby, the cavity 150 passes through the entire thickness of the electrically insulating layer structure 102 and the two electrically conductive layer structures 104. A material removal process step, for example a mechanical drilling step or a laser drilling, may form the cavity 150. A lateral wall of the cavity 151 may defined by the electrically insulating layer structure 102 and the two electrically conductive layer structures 104. Additionally, a lateral wall of the cavity 151 may have a direction being parallel to thickness direction Z.

Figure 1B shows a cross-sectional view of a preform of a component carrier 500 as an exemplary embodiment of the present invention. In addition to Figure 1A, the preform of the component carrier 500 comprises a temporary aid structure 510 and an adhesive material 190. The temporary aid structure 510 may comprise an organic polymeric material comprising adhesive properties. The temporary aid structure 510 is provided at the bottom main surface of the stack 110. The bottom wall of the cavity 150 may be defined by a surface portion of the temporary aid structure 510. According to the exemplary embodiment, the temporary aid structure 510 is in direct contact with an electrically conductive layer structure 104. The adhesive material 190 is provided in(side) the cavity 150, in particular at the bottom (wall) of the cavity 150. The adhesive material 190 may partially cover the bottom wall of the cavity 150. In an example, the adhesive material 190 may comprise an (epoxy) glue. In the shown embodiment, the adhesive material 190 comprises a thickness being the same as the thickness of the electrically conductive layer structure. Alternatively, the adhesive material may comprise a thickness being different than the thickness of the electrically conductive layer structure (not shown). The lateral wall of the cavity 151 is free from direct contact with the adhesive material 190. Optionally, the preform of the component carrier 500 may be free from the adhesive material 190. Thereby, a component 140 may be held in place due to the contact with the temporary aid structure 510, which comprises adhesive properties. Alternatively, the component 140 may comprise an adhesive layer for mounting the component 140 on the temporary aid structure 510.

Figure 1C shows a cross-sectional view of a preform of a component carrier 500 as an exemplary embodiment of the present invention. In addition to Figure 1B, the preform of the component carrier 500 comprises a component 140. The component 140 comprises two connection terminals 141. Alternatively, the component may comprise one connection terminal or a plurality, for example at least 10, connection terminals. In an example, the component 140 may be an active component e.g. a MOSFET. Alternatively, the component 140 may be a passive component. The component 140 is provided such that the connection terminals 141, in particular a respective main surface of the respective connection terminals, are in contact with the temporary aid structure 510. Additionally, the component 140 is in direct contact with the adhesive material 190. The adhesive material 190 is in contact with a main surface of the component 140 and with a lateral surface of the connection terminal 141. The component 140 is free from direct contact with a lateral wall of the cavity 151. A gap or a space 160 is provided between a lateral wall of the component 140 and a lateral wall of the cavity 151. In the shown embodiment, a main surface of the component 140 is in the same vertical level as a main surface of the electrically insulating layer structure 102 and/or a main surface of the electrically conductive layer structure 104. A main surface of the component 140 does not protrude outside the cavity 150 and/or a main surface of the stack 110. Preferably, the adhesive material 190 is provided in the cavity 150 such that the insertion of the component 140 in the cavity 150 comprises a fixation of the component 140 in the cavity 150 through the adhesive material 190.

Figure 1D shows a cross-sectional view of a preform of a component carrier 500 as an exemplary embodiment of the present invention. In addition to Figure 1C, the preform of the component carrier 500 comprises an encapsulant material 120. The encapsulant material 120 is provided on a main surface of the component 140, in particular a main surface facing away from the cavity 150. Preferably, the encapsulant material 120 is provided on top of the component 140 only. The encapsulant material 120 may comprise an organic polymeric material. The encapsulant material 120 may be a solid when provided on top of the component 140. Alternatively, the encapsulant material 120 may be liquid when provided on top of the component 140. Preferably, the encapsulant material 120 comprises a first flowable material 121. The encapsulant material 120, in particular the first flowable material 121, may comprise a Tg smaller than 100 °C, in particular in the range from -20 °C to 100 °C. The encapsulant material 120 may be subjected to an exposure of elevated temperatures, in particular temperatures being higher than the Tg of the encapsulant material 120, for example 220 °C. When the encapsulant material 120 is exposed to said elevated temperatures, the encapsulant material 120 may change some physical and/or material properties, for example the viscosity. Thereby the encapsulant material 120 may get at least partially flowable. According to the shown embodiment, the encapsulant material 120 (before the flowing of the respective material inside the cavity 150 - see Figure 1E) has a planar extension smaller than the planar extension of the cavity 150. According to another embodiment, the encapsulant material 120 (before the flowing of the respective material inside the cavity 150 - see Figure 1E) has a planar extension smaller than the planar extension of the at least one component 140. The encapsulant material 120 may be applied by a printing process step or a dispensing process step. Alternatively, the encapsulant material 120 may be applied by a lamination process step. The encapsulant material 120 protrudes over a main surface (the top main surface) of the stack 110. Preferably, the encapsulant material 120 is free from fibers. Additionally or alternatively, the encapsulant material 120 may comprise inorganic fillers, for example reinforcement glass-spheres. The encapsulant material 120 may comprise a filler content in the range from 0% to 90%. In the case that the encapsulant material 120 is provided as a liquid on top of the component 140, the filler content may be in the range from 0% to 50%. In the case that the encapsulant material 120 is provided as a solid on top of the component 140, the filler content may be in the range from 50% to 90%.

Figure 1E shows a cross-sectional view of a component carrier 100 as an exemplary embodiment of the present invention. In addition to Figure 1D, the component carrier 100 comprises a planar pushing element 200. The planar pushing element 200 is provided on top of the stack 110. Additionally, the planar pushing element 200 is in direct contact with the encapsulant material 120. During the process step from Figure 1D to 1E elevated temperatures, for example 220 °C may be applied to the stack 110. Optionally, the planar pushing element 200 may be heated to 220 °C and may transmit the heat to the stack 110, in particular the encapsulant material 120. Additionally, the planar pushing element 200 may provide a force, for example pressure, to the stack 110. Due to the impact of the forces and/or elevated temperatures applied on the stack 110, in particular the encapsulant material 120, the encapsulant material 120 partially becomes flowable. Preferably, the planar pushing element 200 is moved, wherein the moving direction being parallel to stacking direction Z and towards the stack. Due to this movement direction, the encapsulant material 120 may get squeezed and therefor expands towards a lateral direction. In other words, the flowing of the encapsulant material 120 may be realized by a pressure of the planar pushing element 200. The material, for example the first flowable material 121, of the encapsulant material 120 is flowed by imparting mechanical and/or thermal energy to the encapsulating material 120. The planar pushing element 200 may stop at a vertical position, at which a main surface, in particular the bottom surface, of the planar pushing element 200 is in contact with a main surface of the electrically conductive layer structure 104 and/or the stack 110. Due to the planar pushing element 200, the encapsulant material 120 may get a planar main surface, in particular a top main surface extending in a lateral direction being perpendicular to stacking direction Z. Additionally or alternatively, the encapsulant material 120 may follow the contour and/or surface of the planar pushing element 200. The process step of flowing the encapsulant material 120 is configured so that the encapsulant material 120 flows first on the surface of the component 140 on which the encapsulant material 120 is provided, in particular from a central portion of the main surface of the component towards a peripheral portion and/or an edge, and secondly in a space or a gap 160 between a lateral wall of the cavity 151 and a lateral wall of the component filling said space 160. Additionally, the process step of the flowing of the material of the encapsulant material 120 inside the cavity 150 embedding the component 140 is performed in a vacuum environment. The encapsulant material 120 may have substantially the same volume as the volume inside the cavity 150 with the inserted component 140. The encapsulant material 120 is in direct contact with a first main surface, a lateral wall and a second main surface of the component 140. According to a preferred embodiment, the process step of flowing the encapsulant material 120 is configured so that the encapsulant material 120 flows such that a portion of the flowable material fills a space 160 between the second main surface of the component 140 and a main surface defined by the cavity 150. Additionally or alternatively, the process step of flowing the encapsulant material 120 is configured so that the encapsulant material 120 may flow on a second main surface of the component 140. Preferably, the encapsulant material 120 is in direct contact with a lateral wall of the component 140 and/or a lateral wall of the cavity 151. Additionally, the encapsulant material is in direct contact with an electrically conductive layer structure 104, in particular two electrically conductive layer structure 104 composing a lateral wall of the cavity 151. The electrically conductive layer structure 104 is provided on a main surface of a layer structure delimiting the cavity 150, said electrically conductive layer structure 104 being configures as a stop layer deliming the flowing of the encapsulant material 120 flowed from the cavity 150, in particular delimiting the flowing of the encapsulant material 120 in a lateral direction. The encapsulant material 120 may be in contact with the adhesive material 190. This may be seen in a cross-sectional view being parallel shifted to the cross-sectional view shown in Figure 1E.

Figure 1F shows a cross-sectional view of a component carrier 100 as an exemplary embodiment of the present invention. In comparison to Figure 1E, the planar pushing element 200 and the temporary aid structure 510 are removed. According to the manufacturing method from Figure 1E to Figure 1F, the planar pushing element 200 is provided temporarily. Thereby, the respective electrically conductive layer structure 104, the adhesive material 190, the connection terminals 141 of the component 140 are exposed at a main surface of the stack 110. Additionally, the encapsulant material 120 is exposed at both opposed main surfaces of the stack 110.

Optionally, a further electrically insulating layer structure 102 and a further electrically conductive layer structure 104 may be applied on an exposed surface, in particular both opposed main surfaces, of the stack 110. The further electrically insulating layer structure 102 and the further electrically conductive layer structure may form a build up layer and/or a redistribution layer. The further electrically conductive layer structures 104 may be patterned. Electrically through connections 105 in form of metal filled vias may electrically connect adjacent electrically conductive layer structures 104 in regard to stacking direction Z. Additionally or alternatively, the electrically through connection 105 may electrically connect a connection terminal with a further electrically conductive layer structure 104. The further electrically insulating layer structures 102, the further electrically conductive layer structures 104 and the electrically through connections 105 are depicted with dashed lines in the shown embodiment.

A first method of manufacturing the component carrier 100 may include the process step as described from Figure 1A to Figure 1F.

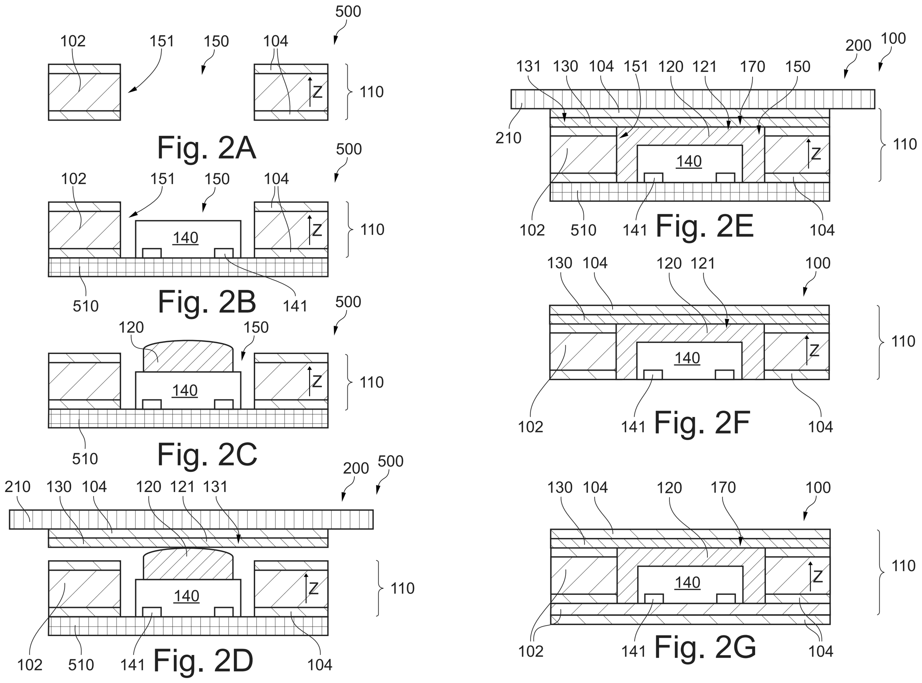

Figure 2A shows a cross-sectional view of a preform of a component carrier 500 as an exemplary embodiment of the present invention. Preferably, the preform of the component carrier 500 is the same as described in Figure 1A.

Figure 2B shows a cross-sectional view of a preform of a component carrier 500 as an exemplary embodiment of the present invention. In addition to Figure 2A, the preform of the component carrier 500 comprises a component 140 and a temporary aid structure 510. The temporary aid structure 510 is the same as described in Figure 1B. In comparison to Figure 1B, the component 140 in Figure 2B comprises two connection terminals 141, which are indented in the component 140. A main surface of the connection terminal 141 may be at the same vertical level in regard to stacking direction Z as a main surface of the component 140. The two respective connection terminals 141 are provided at the same main surface of the component 140. The component 140, in particular a main surface of the component 140, is in direct contact with the temporary aid structure 510. The adhesive properties of the temporary aid structure 510 may fix the component 140 at an intended position.

Figure 2C shows a cross-sectional view of a preform of a component carrier 500 as an exemplary embodiment of the present invention. In addition to Figure 2B, the preform of the component carrier 500 comprises an encapsulant material 120. As described in Figure 1D, the encapsulant material 120 is provided at a main surface, in particular the top surface, of the component 140. Additionally, the provision of the encapsulant material 120 on the component 140 is provided after the insertion of the component 140 inside the cavity 150.

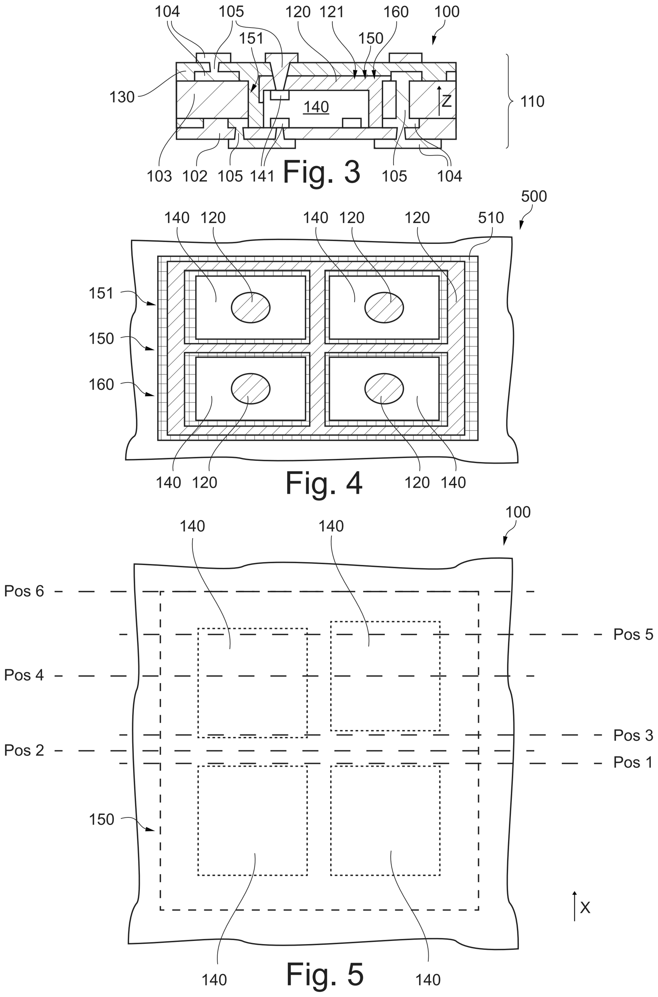

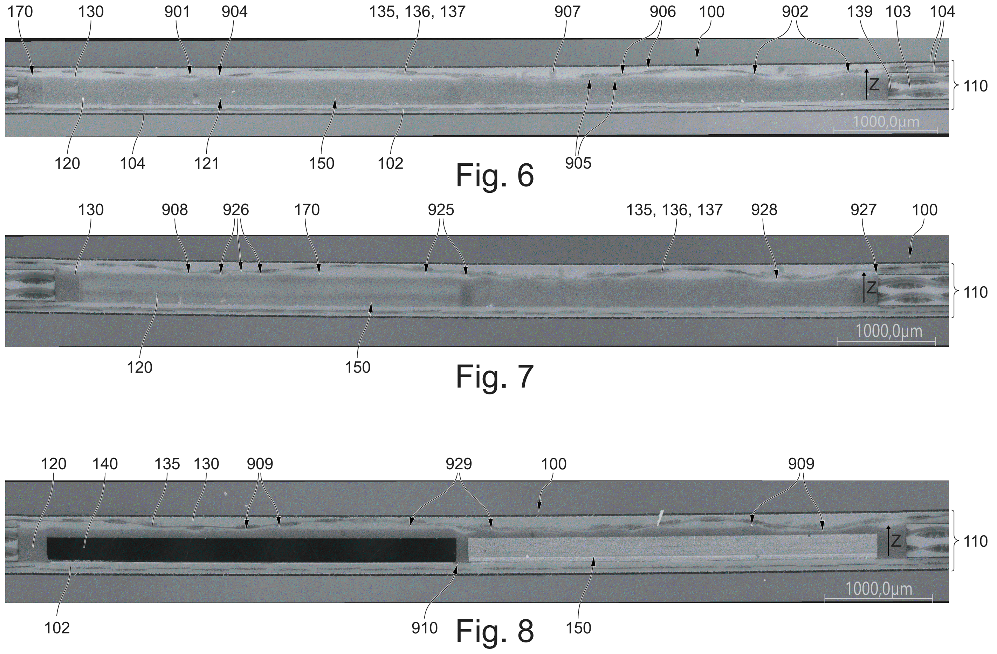

Figure 2D shows a cross-sectional view of a preform of a component carrier 500 as an exemplary embodiment of the present invention. In addition to Figure 2C, the preform of the component carrier 500 comprises a planar pushing element 200. The planar pushing element 200 comprises a further material 130, an electrically conductive layer structure 104 and a pushing plate 210. According to the shown embodiment, the method of manufacturing to component carrier 100 comprises providing a further material 130 on the encapsulant material 120, said further material 130 comprises fillers 135 embedded therein. Preferably, the further material 130 comprises fillers 135 (see Figure 6) and a second flowable material 131. Still referring to Figure 2D, further material 130, in particular the second flowable material 131, may comprise a Tg larger than 100 °C, in particular in the range from 100 °C to 280 °C. The further material 130 may be subjected to an exposure of elevated temperatures, in particular temperatures being higher than the Tg of the further material 130, for example 220 °C. Alternatively, the further material may be subjected to an exposure of elevated temperatures, for example 280 °C. When the further material 130 is exposed to said elevated temperatures, the further material 130 may change some physical and/or material properties, for example the viscosity. Thereby the further material 130 may get at least partially flowable. Preferably, the encapsulant material 120 and the further material 130 are different. Preferably, when applying elevated temperatures, for example 220 °C, the viscosity of the encapsulant material 120 may be smaller than the viscosity of the further material 130. Additionally or alternatively, the gelation of the encapsulant material 120 may be reached earlier than the gelation of the further material 130 during processing, for example when elevated temperatures are applied. According to an embodiment, the further material 130 comprises fillers 135 embedded therein (see Figure 5). The pushing plate 210 may have an extension in planar direction which is larger than a planar direction of the further material 130 and/or the electrically conductive layer structure 104. In the shown embodiment, the planar pushing element 200 is provided such, that a main surface of the planar pushing element is parallel to a main surface of the stack 110. The planar pushing element 200 may be in direct contact with the encapsulant material 120. The planar pushing element 200 may be distanced from the electrically conductive layer structure 104 of the stack 110. Preferably, the further material 130 and the electrically conductive layer structure 104 stick to the pushing plate 210. Alternatively, the further material 130 and the electrically conductive layer structure 104 are provided on top of the encapsulant material 120 and/or the stack 110 without sticking to the pushing plate 210. The electrically conductive layer structure 104 of the planar pushing element 200 may be sandwiched between the further material 130 and the pushing plate 210. Additionally, the further material 130 may face the stack 110 and/or the encapsulant material 120.

Figure 2E shows a cross-sectional view of a component carrier 100 as an exemplary embodiment of the present invention. In comparison to Figure 2D, the planar pushing element 200 moved towards the stack 110. Preferably, elevated temperatures and/or pressure is applied on the further material 130, the encapsulant material 120 and/or the stack 110. The movement of the planar pushing element 200 may be such, that it moves in stacking direction Z toward the stack 110, until the further material 130 gets in contact with another electrically conductive layer structure 104, in particular defined by the stack 110. The elevated temperatures and/or pressure may be provided by the pushing plate 210. Thereby, the encapsulant material 120 may fill the entire volume of the cavity 150 which is not occupied by the component 140. The further material 130 may be parallel aligned with the electrically insulating layer structure 102. The provision of the planar pushing element 200 to the stack 110 may comprise a lamination process step. Thereby, the stack 110 may be enlarged by the further material 130 and the electrically conductive layer structure 104 of the planar pushing element 200. The encapsulant material 120 comprising the first flowable material 121 may be brought in a flowable state - filling the cavity 140 - and afterwards the further material 130 comprising the second flowable material 131 may be brought in a flowable state. Since the encapsulant material 120 having a Tg lower than the Tg of the further material 130, the encapsulant material 120 may get (at least partially) flowable before the further material 130 gets (at least partially) flowable. At elevated temperatures the encapsulant material 120 may undergo a curing reaction. The curing reaction may occur after the encapsulant material 120 become (at least partially) flowable and/or flowed into the cavity 150. Thereby, the encapsulant material 120 solidifies (again) due to an ongoing curing reaction undergoing gelation; however, at this stage the encapsulant material 120 may be still plastic. Simultaneously or thereafter, the further material 130 may become (at least partially) flowable. The further material 130 may at least partially flow and/or may get pushed (due to the applied pressure) toward the encapsulant material 120. Thereby, the further material 130 may get in intimate contact with the encapsulant material 120 forming a boundary profile 170. The embedded fibers of the further material 130 may affect the shape of the boundary profile 170 (not shown; further discussed below). At elevated temperatures the further material 130 may undergo a curing reaction. Thereby, the further material 130 solidifies (again) due to an ongoing curing reaction undergoing gelation. According to the exemplary embodiment, the further material 130 is provided by the planar pushing element 200. Preferably, the planar pushing element 200 is a rigid body. The planar pushing element 200, in particular the further material 130 and/or the electrically conductive layer structure 104 of the planar pushing element 200, may remain attached to the flowed material of the encapsulant material 120, in particular the first flowable material 121. The planar pushing element 200 is and/or comprises a layer, for example an electrically conductive layer 104. The planar pushing element 200 may comprise curable material, for example the further material 130. Additionally or alternatively, the planar pushing element 200 may be fully cured, in particular the further material 130 may be fully cured, during or after the flowing of the flowable material of the encapsulant material 120. The planar pushing element 200 may comprise organic material and/or the further material 130. The encapsulant material 120 may be in contact with the at least one electrically conductive layer structure 104, the electrically insulating layer structure 102, the further material 130, the component 140, the connectional terminal 141. This may ensure a high integrity of the stack 110. As can be seen in the shown embodiment, the further material 130 is in direct contact with the at least one electrically conductive layer structure 104, in particular a main surface of the electrically conductive layer structure 104 and a lateral wall of the electrically conductive layer structure defining a lateral wall of the cavity 151, and/or the electrically insulating layer structure 104 and/or the encapsulant material 120.

Figure 2F shows a cross-sectional view of a component carrier 100 as an exemplary embodiment of the present invention. In comparison to Figure 2E, the temporary aid structure 510 and the pushing plate 210 are removed.

Figure 2G shows a cross-sectional view of a component carrier 100 as an exemplary embodiment of the present invention. In addition to Figure 2F, the another electrically insulating layer structure 102 and another electrically conductive layer structure 104 is provided to the stack 110. Preferably, the stack 110 comprises the other electrically insulating layer structure 102 and the other electrically conductive layer structure 104. The other electrically conductive layer structure 104 is provided at an exposed main surface of the stack 110, in particular the bottom main surface of the stack 110. The other electrically insulating layer structure 102 is in contact with the encapsulant material 120, the electrically conductive layer structure 104 and the component 140. This may ensure that the component 140 is fully embedded. Additionally the other electrically insulating layer structure 102 is sandwiched between the other electrically conductive layer structure 104 and the component 140 and/or between the other electrically conductive layer structure 104 and the encapsulant material 120 and/or between the other electrically conductive layer structure 104 and the conductive layer structure 104 in regard to stacking direction Z.

A second method of manufacturing the component carrier 100 may include the process step as described from Figure 2A to Figure 2G. According to an embodiment, the method of manufacturing to component carrier comprises providing a stack 110 comprising at least one electrically conductive layer structure 104 and at least one electrically insulating layer structure 102; providing a cavity 150 at least partially extending in the stack 110; inserting at least one component 140 in the cavity 150; providing an encapsulant material 120 on the component 140 and flowing the encapsulant material 120 inside the cavity 150 at least partially embedding the component 140. The encapsulant material 120 may at least partially fill the cavity 150. Optionally, the encapsulant material 120 may partially fill the cavity 150 and may be free from contact with an electrically conductive layer structure 104 defining a sidewall of the cavity 150. According to a preferred embodiment the method of manufacturing to component carrier further comprises providing a further material 130 on the encapsulant material 120, said further material comprises fillers 135 embedded therein and forming a boundary profile 170 defined by flowing the encapsulant material 120 and the further material 130 against each other, so that the fillers 135 of the further material 130 affects the shape of the boundary profile 170 (further described in detail below).

Figure 3 shows a cross-sectional view of a component carrier 100 as an exemplary embodiment of the present invention. The component carrier 100 comprises a stack 110 comprising an electrically insulating layer structure composes as a core layer structure 103, a further electrically insulating layer structure 102 and four electrically conductive layer structure 104. Furthermore, the stack 110 comprises an encapsulant material 120, a further material 130 and a component 140. An electrically conductive layer structure 104 may be provided between the core layer structure 103 and the further electrically insulating layer structure 102 (in regard to stacking direction Z). Additionally or alternatively, an electrically conductive layer structure 104 may be provided between the further material 130 and the core layer structure 103 (in regard to stacking direction Z). An electrically conductive layer structure 104 may be laterally provided between the further material 130 and the further electrically insulating layer structure 102 or the encapsulant material 120. The electrically conductive layer structures 104, in particular adjacent electrically conductive layer structure in regard to stacking direction Z, are interconnected with each other by an electrically through connections 105. The electrically through connection 105 may be a metal filled through connection, for example comprising copper. The electrically through connection 105 may be manufactured by a mechanical drilling process and/or a laser drilling process in combination with a plating process. A cavity 150 may be formed in the stack 110, wherein the cavity thickness may extend between two vertically adjacent electrically conductive layer structures 104, in particular the two central electrically conductive layer structures. According to the shown embodiment, a lateral wall of the cavity 151 has a stepped structure. Preferably, an electrically conductive layer structure 104 is configured as a stepped structure encircling the external profile of the cavity 150. A component 140 is provided at the bottom wall defined by the cavity 150. The component 140 comprises three connection terminals 141. Two of the connection terminals 141 are provided at one main surface of the component 140 and one connection terminal 141 is provided at the opposed other main surface of the component 140. Optionally a plurality of connection terminals 141 may be provided at both opposed main surfaces of the component 140. The connection terminals 141 may be connected to a respective electrically conductive layer structure 104 by an electrically through connection 105. The electrically through connection 105 may comprise at least two layers, in particular a seed layer and a plated layer. One of the two layers of the electrically through connection 105, in particular the seed layer, may be in direct contact with the connection terminal 141 and/or the further material 130 and/or the encapsulant material 120 and/or the electrically conductive layer structure 104. The encapsulant material 120 is partially embedding the component 140. As can be seen a portion of a lateral wall of the component 140 is free of contact with the encapsulant material 120. Said portion of the component 140 being free of contact with the encapsulant material 120 is in contact with the further material 130. The encapsulant material 120 has a smaller volume than the volume inside the cavity 150 with inserted component 140. In the shown embodiment, the further material 130 and the encapsulant material 120 fully fill the volume of the cavity which is not occupied by the component 140. The reason for this may be that the volume of the encapsulant material 120 is not able to fully fill the cavity 150. Therefore the remaining volume of the cavity 150 may be filled by the further material 130. When comparing the process steps of Figure 2D and 2E, an encapsulant material 120 is provided on top of the component 140. When applying elevated temperatures and/or pressure, the encapsulant material 120, in particular the first flowable material 121, may get at least partially flowable and starts to flow toward the edges of the component 140. Afterwards, the encapsulant material 120 may flow along a lateral wall of the component. A gap 160 on the right side of the component 140 between the lateral side of the cavity 151 and the lateral side of the component may be filled by the encapsulant material 120. Since the volume of the encapsulant 120 is too small to fully fill the cavity 150 which is not occupied by the component 140 the encapsulant material 120 is only provided at a top portion of the lateral wall of the component 140 (see left side of the component). Additionally, the maximum vertical thickness of the encapsulant material 120 is smaller the thickness or depth of the cavity 150. In other words, a main surface of the encapsulant material 120 is at a different vertical position in regard to a main surface of a laterally adjacent electrically conductive layer structure 104. The volume of the cavity being not occupied by the component 140 and the encapsulant material 120 is filled by the further material 130, in particular the second flowable material 131. A gap 160 between a lateral wall of the cavity 151 and a lateral wall of the component 140 is filled by the further material 130, in particular the second flowable material 131, and the encapsulant material 120, in particular the first flowable material 121. Preferably, the further material 130 and the encapsulant material 120 are provided laterally adjacent one to each other inside the gap 160. Alternatively, the volume of the cavity being not occupied by the component 140 and the encapsulant material 120 is filled by the further material 130 may be filled such, that the encapsulant material 120 fully covers the bottom wall of the cavity. Additionally, the component 140 may be encapsulated by the encapsulant material 120, wherein the encapsulant material 120 is in direct contact with two apposed lateral walls of the component and a main surface of the component. The main surface of the encapsulant material 120 being opposed to the main surface in direct contact with the bottom wall of the cavity may have substantially horizontal extension. The further material 130 may be applied on top of the encapsulant material 120 and may fill the rest of the volume of the cavity, which is not occupied by the encapsulant material 120 and the component 140 - see Figure 7. Still referring to Figure 3, the stepped structure of the electrically conductive layer structure 104 may be in contact with the further material 130 and/or the encapsulant material 120. Further build-up layers may be added on both sides of the stack 110 in order to achieve the final component carrier (note shown). An electrically conductive layer structure 104 is exposed at a main surface of the stack 110. The exposed electrically conductive layer structure 104 may comprise a surface finish, for example comprising nickel and/or gold. This may allow an electrical connection to surface mounted components (not shown). Figure 3 may be a result of a method comprising providing the further material 130 in the cavity 150.

Figure 4 shows a top view of a preform of a component carrier 500 as an exemplary embodiment of the present invention. The preform of the component carrier 500 may be similar to the preform of the component carrier as shown in Figure 2C. In comparison to Figure 2C, the preform of the component carrier 500 comprises four component 140 provided in the cavity 140. Preferably, the four components 140 are distributed within the planar extension of the cavity 150. According to the shown embodiment, the four components 140 are provided in the cavity 140 in a patterned distribution. As can be further seen, the four components 140 are provided in the cavity 150 forming rows and columns of components 140 aligned parallel one to each other. During the manufacturing of the preform of the component carrier 500 a body may be provided on a component 140. Preferably, a body may be provided on each of the four components 140. The body may comprise the encapsulant material 120. In an example, the body may be a dry film. In the shown embodiment, the respective bodies have rounded shape, in particular circular shape, and are provided in the planar center of a top main surface of a respective component 140. Laterally adjacent to a component 140, a further encapsulant material 120 is provided. Preferably, the further encapsulant material 120 comprises the same material and/or physical properties and/or mechanical properties as the encapsulant material 120. The further encapsulant material is provided in the gap 160 between the lateral wall of the cavity 151 and the lateral wall of the component 140. In the shown embodiment, the further encapsulant material 120 is free from direct contact with a component 140 and/or a lateral wall of the cavity 151. Preferably, the further encapsulant material is provided on the bottom wall defined by the cavity 140. In the shown embodiment, the further encapsulant material is provided on the temporary aid structure 510. Preferably, a plurality of further encapsulant material 120 is provided to the preform of the component carrier 500. Additionally, a connection rib may be provided between the plurality of further encapsulant materials 120 such that the at least one connection rib planarly extending between at least two of the plurality of components 140. Preferably, the encapsulant material 120 comprises the connection rib or vice versa. A connection structure may be provided at the preform of the component carrier 500. The connection structure may comprise the encapsulant material 120 or vise versa. During the manufacture of the component carrier, the connection structure may connect the plurality of encapsulant material 120 and/or the further encapsulant material 120 one to each other. This may be done during application of elevated temperatures and/or pressure, for example during a lamination process. Thereby a frame structure of encapsulant material 120 is created. Alternatively, a (further) encapsulant material 120 and/or a plurality of (further) encapsulant materials 120 is provided such that a frame structure from a top view is formed. Preferably, the frame structure is configured to be inserted in the cavity 150 before the respective further material 130. During the production of the component carrier 100, the respective encapsulant materials 120 and/or further encapsulant materials 120 may intermingle together and/or get in contact with each other, preferably forming a common encapsulant material and at least partially, in particular fully, filling the cavity 150. Thereby the common encapsulant material may get in direct contact with (a, in particular all, lateral walls of) the respective components 140 and preferably void-free embed them. Alternatively, one encapsulant material 120 may be provided at a plurality of components 140 (not shown).

Figure 5 shows a top view of a component carrier 100 as an exemplary embodiment of the present invention. The layer structures of component carrier 100 may be similar to the component carrier 100 shown in Figure 2G. However, in comparison the component carrier in Figure 5 comprises four component 140 embedded therein, similar to Figure 4. The outlines of the respective components 140 are indicated by dashed lines as well as the outline of the cavity 150 is also indicated by a dashed line in regard to planar directions. Figure 5 also comprises horizontally straight line indicating respective planes when doing a cross-sectional cutting of the component carrier 100. The respective horizontally straight lines are linked to a certain vertical position inside the component carrier 100. Position 1 is abbreviated in Figure 5 with "Pos 1". Position 2 is abbreviated in Figure 5 with "Pos 2". Position 3 is abbreviated in Figure 5 with "Pos 3". Position 4 is abbreviated in Figure 5 with "Pos 4". Position 5 is abbreviated in Figure 5 with "Pos 5". Position 6 is abbreviated in Figure 5 with "Pos 6". A material removal process, for example by grinding, may remove the material of the component carrier 100. The material removal process may be applied at the bottom of the component carrier 100 and proceeded in forward direction X. The material of the component carrier 100 may be removed according to a horizontal plane until it is stopped at a certain position, for example position 1. Afterwards a cross-section image may be taken - see Figure 6. Thereafter the material removal process may be continued and stopped again at another position, for example position 2. This sequence of material removal and taking cross-section images may be repeated. Preferably, this may created cross-sectional images according to position 1 to position 7. Preferably, the respective cross-sectional images are created out of the same component carrier 100. Even if the materials inside the component carrier 100 at respective positions (compare position 1 to position 7) are the same, some of the related product features vary, which is explained in the following in detail.

Figure 6 shows a microscopic image of a cross-section view of a component carrier 100 according to an exemplary embodiment. The component carrier 100 corresponds to position 1 as shown in Figure 5. The component carrier 100 comprises a stack 110 which is similar to the stack as shown in Figure 3. The core layer comprises other fillers 139, in particular other fibers. A core layer structure 103 is sandwiched between two electrically conductive layer structure 104. A cavity 150 extends vertically through the two electrically conductive layer structure 104 and the core layer structure 103. The other fibers 139 of the core layer 105 may at least partially define a lateral wall of the cavity 151. At the bottom main surface of the core layer structure 103, in particular in direct contact with an electrically conductive layer structure 104, a further electrically insulating layer structure 102 and an electrically conductive layer structure 104 is provided. At the top main surface of the core layer structure 103, in particular in direct contact with an electrically conductive layer structure 104, a further material 130 in form of an electrically conductive layer structure 104 is provided. In the shown embodiment, an encapsulant material 120 is provided inside the cavity 150. The encapsulant material 120 comprises fiber-free fillers. The further material 130 comprises fillers, in particular a plurality of fibers 135, for example glass-fibers. The further material 130 comprises a woven textile 136 embedded therein. The plurality of fibers 135 may be configured to form the woven textile embedded in the further material 130. The plurality of fibers 135 may be configured to form a plurality of warps and wefts 137. Between the further material 130 and the encapsulant material 120 in regard to stacking direction Z, a boundary profile 170 is formed. The further material 130 flowed against the encapsulant material 120 defines with the encapsulant material 120 the boundary profile 170. According to the shown embodiment, the fillers 135, in particular the fibers, embedded in the further material 130 affect the shape of the boundary profile 170. Preferably, the shape of the boundary profile partially follows the shape of the fillers. This can be seen indicated by the reference sign 901. The position of fibers 135, in particular an intersection between warps and wefts 137, may manipulate the shape of the boundary profile 170. As can be further seen by the shown embodiment, the boundary profile 170 comprises an irregular surface. In particular, the boundary profile 170 may not be flat. The boundary profile 170 may comprise a structured shape. The encapsulant material 120 may define a bumped shape, in particular bumped shapes, around the cavity profile. This can be seen indicated by the reference sign 902. Preferably, the bumped shapes comprise and/or define protrusion along a planar direction and/or a thickness direction or stacking direction Z. The encapsulant material 120 inside the cavity 150 defines an irregular surface facing the further material 130. The irregular surface of the encapsulant material 120 and/or the irregular surface of the boundary profile 170 can be seen indicated by reference sign 904. The boundary profile 170 comprises a wave-like shape extension in regard to a cross-sectional view. Preferably, the wave-like shape extension comprises a variable wave-like shape within the respective surface extension. This can be seen indicated by the reference sign 905. The fibers 135 also comprise a wave-shape extension. This can be seen indicated by the reference sign 906. By comparison of the wave-shape extension of the fibers 906 with the wave-shape extension of the boundary profile 905 it can be seen that the wave-shape extension of the boundary profile 905 is at least partially different from the wave-shape extension of the fillers 906. The difference of the wave-shape extension of the boundary profile 905 and the wave-shape extension of the fillers 906 comprises different heights in regard to stacking direction. Additionally or alternatively, an amplitude and/or a frequency of the wave-shape extension of the boundary profile 905 may be different than an amplitude and/or a frequency of the wave-shape extension of the fibers 906. The difference of the wave-shape extension of the boundary profile 905 and the wave-shape extension of the fillers 906 may comprise offset wave evolutions. The difference of the wave-shape extension of the boundary profile 905 and the wave-shape extension of the fillers 906 comprises valley and peaks of the respective waves offset one to each other. The figure also shows, that the encapsulant material 120 externally exceed a planar extension of the cavity 150. This can be seen indicated by the reference sign 903. Preferably, the encapsulant material 120 after the flowing of the respective insulating material, in particular the first flowable material 121, inside the cavity 150 defines a portion external to the cavity 150. A portion of the encapsulant material 120 extends through the thickness of the further material 130 in regard to stacking direction Z forming a bulge protrusion 907. Additionally, the encapsulant material 120 may have a greater volume, in particular at least 1% greater, than the volume inside the cavity 150 with the inserted component 140.

Figure 7 shows a microscopic image of a cross-section view of a component carrier 100 according to an exemplary embodiment. The component carrier 100 corresponds to position 2 as shown in Figure 5. The stack 110 may be similar as described in Figure 6. As can be seen in Figure 7, at least a portion of the boundary profile 170 follows the external footprint of the warps and wefts 137. This can be seen indicated by the reference sign 908. Preferably, at least a portion of the boundary profile 170 following the external footprint of the warps and wefts 137 protrudes towards internal of the cavity 150. Even if in Figure 7 the cross-section cutting plane does not intersect with a component - see position 2 in Figure 5 - a shadow in the cross-section image can be seen, which corresponds to the close by components.

Figure 8 shows a microscopic image of a cross-section view of a component carrier 100 according to an exemplary embodiment. The component carrier 100 corresponds to position 3 as shown in Figure 5. In addition to Figure 5, the stack comprises a component 140. The component 140 is sandwiched between the encapsulant material 120 and the electrically insulating layer structure 102. A second component is provided in close proximity to the component 140. However, the second component is shifted in a direction being perpendicular to stacking direction Z compared to the component 140 and thus is shown in the current cross-sectional view. The shift of the second component can be seen in Figure 5. As illustrated in Figure 5, the dashed line linked to position 3 intersects with one component 140 (only). Due to a shift of another component 140 in a forward direction X, wherein the shift is parallel to the dashed line, the other component 140 does not intersect with the dashed line linked to position 3. A shadow created by the second component and its circumferential contour can be seen. Still referring to the Figure 8 and as described above, a boundary profile 170 is formed between the encapsulant material 120 and the further material 130, wherein the boundary profile 170 is defined by the further material 130 flowed against the encapsulant material 120. The boundary profile 170 comprises a plurality of recesses and a plurality of protrusions 909, said protrusions extending toward the internal of the cavity 150. Preferably, the plurality of recesses and the plurality of protrusions 909 follow the contour of the at least a portion of the plurality of fibers 135. As can be seen in the shown embodiment, a first recess and/or a first protrusion 909 is smaller than a second recess and/or a second protrusion 909 (compare the respective reference signs). Preferably, the first recess and/or the first protrusion 909 is in closer proximity to the at least one component 140 than the second recess and/or the second protrusion 909 (compare the respective reference signs).

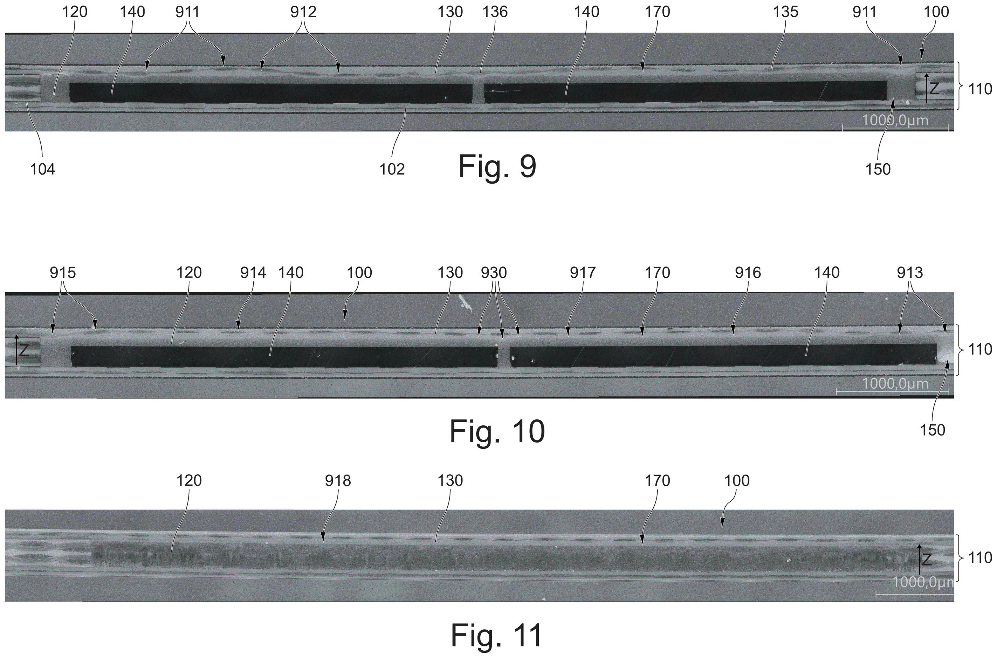

Figure 9 shows a microscopic image of a cross-section view of a component carrier 100 according to an exemplary embodiment. The component carrier 100 corresponds to position 4 as shown in Figure 5. In comparison to Figure 8, the stack 110 comprises two components 140 embedded in a cavity 150. A boundary profile 170 is formed between an encapsulant material 120 and the further material 130, wherein the boundary profile 170 is defined by the further material 130 flowed against the encapsulant material 120. The further material 130 comprises fibers 135, in particular forming a woven textile 136. The extension of the plurality of fibers 135, in particular of the formed woven textile 136, changes along the thickness direction Z of the stack 110 along a planar extension of the cavity 150. This can be seen indicated by the reference sign 911. The position of the fillers 135 changes along a wave-shaped extension in regard to a cross-sectional view. This can be seen indicated by the reference sign 911. At least one protrusion resulting from the wave-shaped extension is closer to the internal of the cavity 150 than protrusions or valleys of other portions of the wave-shaped extended fillers (compare the reference signs 911). According to the shown embodiment, the boundary profile 170 has a vertical distance from the fillers 135 that is variable within the respective surface extension. This can be seen indicated by the reference sign 912. According to the shown embodiment, the component carrier 100 comprises a stack 110 comprising at least one electrically conductive layer structure 104 and at least one electrically insulating layer structure 102; a cavity 150 at least partially extending in the stack 110; at least one component 140 provided in the stack 110; an encapsulant material 120 flowed in the cavity 150, at least partially embedding the at least one component 140 in the cavity 150; a further material 130 flowed against the encapsulant material 120, defining with the encapsulant 120 material a boundary profile 170; wherein the further material 130 comprises fillers 135 embedded therein, said fillers 135 affecting the shape of the boundary profile 170.

Figure 10 shows a microscopic image of a cross-section view of a component carrier 100 according to an exemplary embodiment. The component carrier 100 corresponds to position 5 as shown in Figure 5. The component carrier 100 comprises a stack 110 similar to the component carrier 100 shown in Figure 9. The stack 110 comprises two components 140 embedded in a cavity 150. A boundary profile 170 is formed between an encapsulant material 120 and the further material 130, wherein the boundary profile 170 is defined by the further material 130 flowed against the encapsulant material 120. According to the shown embodiment, the shape of the boundary profile 170 is more affected by the fillers 135 at at least one lateral area of the cavity 150 than the shape of the boundary profile 170 at a central area of the cavity. This can be seen indicated by the reference sign 913. Additionally, the vertical extension of the fillers 135 may be affected by the presence of the component 140 embedded in the cavity 150. This can be seen indicated by the reference sign 914. The fillers 135 overlapping with the cavity 150 and not overlapping with the component 140 embedded in the cavity 150 are more protruding into the cavity 150 than the filler 135 overlapping with the component 140. As can be further seen by the shown embodiment is, that the shape of the boundary profile 170 is more affected by the presence of the component 140 than the corresponding overlapping fillers 135. This can be seen indicated by the reference sign 916. Furthermore, a portion of the boundary profile 170 overlapping with the component 140 in regard to a cross-sectional view is free of irregularities. This can be seen indicated by the reference sign 917.

As this cross-sectional image is even closer to a lateral wall of the cavity 151 but still intersecting with the components 140, the variation of recesses and protrusions of the boundary profile 170 may be even smaller compared to Figure 9.

Figure 11 shows a microscopic image of a cross-section view of a component carrier 100 according to an exemplary embodiment. The component carrier 100 corresponds to position 6 as shown in Figure 5. The component carrier 100 comprises a stack 110 as described in Figure 6. As can be seen in Figure 5, the cross-section cut is performed at an edge of the cavity 150. A boundary profile 170 is formed between an encapsulant material 120 and the further material 130, wherein the boundary profile 170 is defined by the further material 130 flowed against the encapsulant material 120. According to the shown embodiment, a portion of the boundary profile 170 overlapping with the at least one component along a cross-sectional view is free of irregularities in proximity of the cavity profile. This can be seen indicated by the reference sign 918.

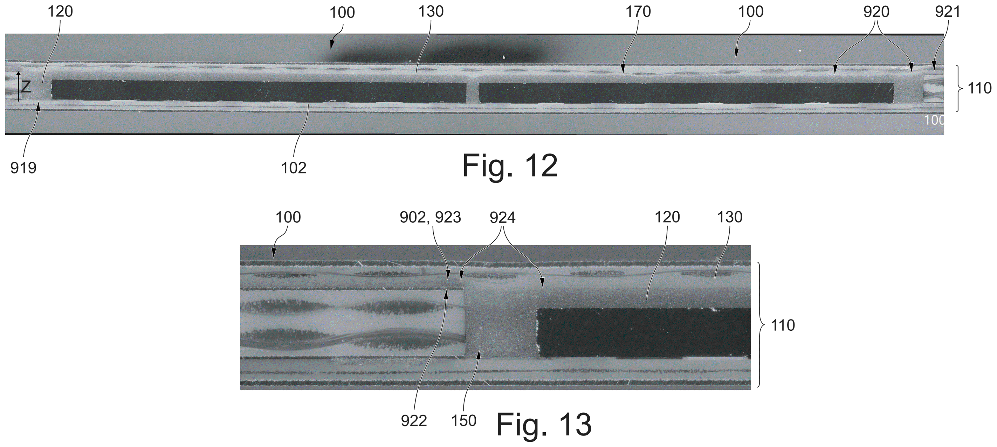

Figure 12 shows a microscopic image of a cross-section view of a component carrier 100 according to an exemplary embodiment. The component carrier 100 comprises a stack 110 similar to the component carrier 100 shown in Figure 9. The stack 110 comprises two components 140 embedded in a cavity 150. A boundary profile 170 is formed between an encapsulant material 120 and the further material 130, wherein the boundary profile 170 is defined by the further material 130 flowed against the encapsulant material 120. According to the shown embodiment, the encapsulant material 120 comprises at least one portion contacting a main surface of a structure, in particular the at least one electrically insulating layer structure 102, delimiting the cavity 150. This can be seen indicated by the reference sign 919. Additionally as can be seen, the boundary profile 170 comprises a first portion and a second portion, said first portion is closer to a central area of the at least one component 140 in comparison to the second portion and the first portion is less affected by the fillers 135 than the second portion. This can be seen indicated by the reference sign 920. The further material 130 comprises fillers, in particular a plurality of fibers 135, for example glass-fibers. The plurality of fibers 135 may be configured to form a plurality of warps and wefts 137. The plurality of fibers 135, in particular the plurality of warps and wefts 137, may affect the exceeding of the encapsulant material 130 beyond the planar extension of the cavity 150. This can be seen indicated by the reference sign 921.

Figure 13 shows a microscopic image of a cross-section view of a component carrier 100 according to an exemplary embodiment. Figure 13 depict a magnified portion of the left-hand side of the component carrier shown in Figure 12. A boundary profile 170 is formed between an encapsulant material 120 and the further material 130, wherein the boundary profile 170 is defined by the further material 130 flowed against the encapsulant material 120. According to the shown embodiment, the encapsulant material 120 externally exceeding the planar extension of the cavity 150 comprises a planar extension parallel to a main surface of at least one of the structures composing the stack 110. Additionally as can be seen in the embodiment, the encapsulant material 120 externally exceeding the planar extension of the cavity 150 comprises an external surface facing away from the cavity 150 having a rounded and/or irregular profile. Further, encapsulant material 120 externally exceeding the planar extension of the cavity 150 comprises a variable thickness. This can be seen indicated by the reference sign 923. The encapsulant material 120 externally exceeding the planar extension of the cavity 150 may comprise bumped shaped 902. The bumped shapes 902 may extend in a lateral direction and/or in stacking direction Z out of the cavity.

According to a further shown embodiment, the encapsulant material 120 externally exceeding the planar extension of the cavity 150 comprises a thickness having a value less than 5 times the value of the thickness of the flowed material on and above the at least one component 140. This can be seen indicated by the reference sign 924.

By comparing Figures 6 to Figure 13, it can be seen that the encapsulant material 120 exceeds the planar extension of the cavity 150 of an irregular amount of said material along the cavity lateral profile. Additionally or alternatively, the encapsulant material 120 externally exceeding the planar extension of the cavity 150 may encircles at least partially the cavity 150.

In general a clear trend can be seen when comparing Figure 6 to Figure 11. The boundary profile 170 may be influenced by several incidents.
a) the shape of boundary profile 170 may be influenced by the shape of the fibers, in particular an intersection between a warp and a weft 137 - see reference sign 901.
b) the closer the boundary profile 170 to an intersection between a warp and a weft 137 in regard to stacking direction Z the more influenced the shape of the boundary profile 170 may be - see reference sign 925.
c) the shape of a portion of the boundary profile 170 between two laterally adjacent intersections of warps and wefts 137 may be less influenced than the shape of a portion of the boundary profile 170 in (direct) association with an intersection between a warp and a weft 137 - see reference sign 926.
d) the shape of the boundary profile 170 may be influenced by the circumference of the cavity 150 - see reference sign 927.
e) the closer the boundary profile 170 to a central portion of the cavity 150 the more the shape of the boundary profile 170 may be influenced - see reference sign 928.
f) the closer the boundary profile 170 to a component 140 in regard to stacking direction Z the less influenced the shape of the boundary profile 170 may be - see reference sign 929.
g) the shape of a portion of the boundary profile 170 between two laterally adjacent components 140 may be more influenced than the shape of a portion of the boundary profile 170 in (direct) association with component - see reference sign 930.

Concluding: a difference between a recess and a protrusion 909 of the boundary profile 170 may be more pronounced in a central portion of the cavity 150 than at a portion close to a lateral wall of the cavity. The shape and/or the intensity of a recess and/or a protrusion 909 may be influenced by the position and/or the geometry and/or the arrangement of one or a plurality of components 140. This may be seen by differently pronounced recesses and/or protrusions 909 of the boundary profile 170.

It should be noted that the term "comprising" does not exclude other elements or steps and the "a" or "an" does not exclude a plurality. Also, elements described in association with different embodiments may be combined.

Implementation of the invention is not limited to the preferred embodiments shown in the figures and described above. Instead, a multiplicity of variants is possible which use the solutions shown and the principle according to the invention, whose scope is defined by the appended claims.

## Claims

1. A method of manufacturing a component carrier (100), the method comprising:
providing a stack (110) comprising at least one electrically conductive layer structure (104) and at least one electrically insulating layer structure (102);
providing a cavity (150) at least partially extending in the stack (110);
inserting at least one component (140) in the cavity (150);
providing an encapsulant material (120) on the at least one component (140);
flowing the encapsulant material (120) inside the cavity (150) at least partially embedding the at least one component (140).

2. A method of manufacturing a component carrier (100) according to claim 1,
wherein the method further comprises providing a further material (130) on the encapsulant material (120), said further material (130) comprises fillers (135) embedded therein.

3. A method of manufacturing a component carrier (100) according to claim 2,
wherein the method further comprises forming a boundary profile (170) defined by flowing the encapsulant material (120) and the further material (130) against each other, so that the fillers (170) of the further material (130) affects the shape of the boundary profile (170).

4. A method of manufacturing a component carrier (100) according to any of claims 1 to 3,
wherein the step of flowing the encapsulant material (120) is configured so that the encapsulant material (120) flows first on the surface of the at least one component (140) on which the encapsulant material (120) is provided, and secondly in a space (160) between a lateral wall of the cavity (151) and a lateral wall of the at least one component (140) filling said space (160).

5. A method of manufacturing a component carrier (100) according to any of claims 1 to 4,
wherein the step of flowing the encapsulant material (120) is configured so that the encapsulant material (120) flows on a second main surface of the at least one component (140).

6. A method of manufacturing a component carrier (100) according to any of claims 1 to 5,
wherein the encapsulant material (120) is provided on top of the at least one component (140) only.

7. A method of manufacturing a component carrier (100) according to any of claims 1 to 6,
wherein the encapsulant material (120) before the flowing of the respective material inside the cavity (150) has a planar extension smaller than the planar extension of the at least one component (140).

8. A method of manufacturing a component carrier (100) according to any of claims 1 to 7,
wherein the encapsulant material (120) after the flowing of the respective material inside the cavity (150) has a planar extension equal or greater than the planar extension of the cavity (150) and/or the at least one component (140).

9. A method of manufacturing a component carrier (100) according to any of claims 1 to 8,
wherein the provision of the encapsulant material (120) on the at least one component (140) is provided after the insertion of the component (140) inside the cavity (150).

10. A method of manufacturing a component carrier (100) according to any of claims 1 to 9,
wherein the flowing of the material of the encapsulant material (120) inside the cavity (150) embedding the at least one component (140) is performed in a vacuum environment.

11. A method of manufacturing a component carrier (100) according to any of claims 1 to 10,
wherein the flowing of the encapsulant material (120) is realized by a pressure of a planar pushing element (200).

12. A method of manufacturing a component carrier (100) according to any of claims 1 to 11,
wherein the planar pushing element (200) is provided temporarily.

13. A method of manufacturing a component carrier (100) according to any of claims 1 to 12,
wherein the material of the encapsulant material (120) is flowed by imparting mechanical and/or thermal energy to the encapsulating material (120).

14. A method of manufacturing a component carrier (100) according to any of claims 1 to 13,
further comprises bringing the encapsulant material (120) in a flowable state and afterwards bringing the further material (130) in a flowable state.

15. A method of manufacturing a component carrier (100) according to any of claims 1 to 14,
further comprises providing an adhesive material (190) in the cavity (150), in particular at the bottom of the cavity,
in particular wherein providing the adhesive material (190) in the cavity (150) such that the insertion of the at least one component (140) in the cavity (150) comprises the fixation of the at least one component (140) in the cavity (150) through the adhesive material (190).
